# EUROPEAN PATENT APPLICATION

(11) **EP 2 216 172 A1**
(43) Date of publication of application: **11.08.2010**
(21) Application number: 08852434.3
(22) Date of filing: 17.11.2008
(51) Int. Cl.: B32B 27/08, B29C 61/06, B32B 7/02, B32B 27/00, B32B 27/30, C09J 7/02, C09J 133/00, H01L 21/301, H01L 21/304, H01L 21/683, B29K 105/02, B29L 7/00, B29L 9/00

(54) **RESIN LAMINATE, PRESSURE SENSITIVE ADHESIVE SHEET, METHOD FOR WORKING ADHEREND USING THE PRESSURE SENSITIVE ADHESIVE SHEET, AND DEVICE FOR SEPARATING THE PRESSURE SENSITIVE ADHESIVE SHEET**

(30) Priority: 19.11.2007 JP 2007299809
(71) Applicant: Nitto Denko Corporation, Ibaraki-shi, Osaka 567-8680 (JP)
(72) Inventor: NISHIO, Akinori, Ibaraki-shi Osaka 567-8680 (JP); KIUCHI, Kazuyuki, Ibaraki-shi Osaka 567-8680 (JP)
(74) Representative: Grünecker, Kinkeldey, Stockmair & Schwanhäusser Anwaltssozietät
(86) International application number: PCT/JP2008/003346
(87) International publication number: WO 2009/066435

(57) **Abstract**

A pressure sensitive adhesive sheet according to the present invention is a resin laminate, including a high thermally shrinkable base layer having relatively high thermal shrinkage ratio, having a ratio (A:B) of the thermal shrinkage ratio in a main shrinkage direction [A (%)] to the shrinkage ratio in a direction perpendicular to the main shrinkage direction [B (%)] of 1:1 to 10:1, and a low thermally shrinkable base layer having relatively low thermal shrinkage ratio, the high and low thermally shrinkable base layers bonded to each other via a self-adhesive layer, wherein the resin laminate bends toward the high thermally shrinkable base layer side when heated from any one direction and can automatically curl from one terminal unidirectionally to form a tubular roll by further heating. The pressure sensitive adhesive sheet can be separated from an adherend smoothly when heated from any one direction. Thus, it can be used, for example, as a pressure sensitive adhesive sheet for semiconductor wafer polishing.

## Description

### Technical Field

The present invention relates to a resin laminate that automatically curls from a terminal to form a tubular roll when a terminal of the resin laminate is heated from any one direction, a pressure sensitive adhesive (pressure-sensitive) sheet of the resin laminate, for example for use in semiconductor wafer polishing (back grinding), that is separated from the adherend semiconductor wafer by automatic curling from the terminal into a tubular roll when heated from any one direction, a method for working (processing) an adherend using the pressure sensitive adhesive sheet, and a device for separating the pressure sensitive adhesive sheet.

### Background Art

Semiconductor chips are produced by preparing a large-diameter semiconductor wafer from a material such as silicon, germanium or gallium arsenic, working the rear surface thereof to a particular thickness (back grinding), and additionally as needed by rear surface-treatment (etching, polishing, etc.), cutting processing and other processings. Recently in further increase of the demand for reduction in thickness and weight of semiconductor materials, semiconductor wafers are required to be thinned to a thickness of 100 µm or less, but such a thin film wafer is very fragile and easily fractured. Thus during semiconductor wafer processing, used is a method of fixing a semiconductor wafer temporarily by using a pressure-sensitive adhesive sheet and separating the pressure-sensitive adhesive sheet for temporary fixation from the semiconductor wafer after desired processing.

Such a pressure-sensitive adhesive sheet for temporary fixation (hereinafter referred to as "back grinding tape") which is generally made of an energy ray-curable adhesive layer, has been used for protection of the semiconductor wafer surface from the stress, grinding water, and grinding grain (silicon dust) applied thereto during a process such as polishing of the semiconductor wafer temporarily bonded and fixed to the adhesive sheet. After the processing step for example of polishing semiconductor wafer, the back grinding tape is separated from the semiconductor wafer, as the adhesive layer is cured by irradiation of energy ray and thus its adhesive power is reduced. However, the back grinding tape remains adhered to the semiconductor wafer surface under atmospheric pressure, even when the adhesive power is reduced by irradiation of energy ray. Thus for separation of the back grinding tape, it is needed to conduct an operation, for example, to peel off the back grinding tape, which caused a problem that the semiconductor wafer is fractured by the stress at the time. In common back grinding tape-separating devices, the back grinding tape is removed in such a manner that the semiconductor wafer-back grinding tape laminate after polishing (hereinafter, referred to as "polished wafer") is fixed on a suction stage, a release tape in the separating device is bonded to the back grinding tape face of the polished wafer, and then the back grinding tape is peeled off with the release tape.

The release tape is bonded to the back grinding tape of the polished wafer in the direction inward from the terminal, and an unneeded back grinding tape is separated, as the release tape is peeled off. However, it is impossible to bond a rectangular release tape to a circumferential back grinding tape adhered to a round semiconductor wafer without excess from the wafer terminal, and practically, the release tape extends out of the back grinding tape, although the length thereof is small. If a semiconductor wafer is thinned further, the excess release tape may adhere for example to the separating device, and if the release tape is peeled off in such a state, the entire semiconductor wafer may be bent, possibly leading to fracture thereof. The fracture of semiconductor wafer described above may be avoided, if the release tape is not bonded to the terminal, but in such a case, even when the release tape is peeled off, the peel stress is not transmitted to the back grinding tape sufficiently, possibly making it difficult to remove the back grinding tape.

JP 2000-129223A discloses a pressure-sensitive adhesive sheet for protection of semiconductor wafers, including a shrinkable film, a rigid film, and an energy ray-curable adhesive layer. The patent application describes that, when the adhesive strength of the adhesive layer is reduced by irradiation of active-energy ray and the shrinkable film is shrunk by particular means, the pressure-sensitive adhesive sheet deforms itself, leading to decrease of a contact area between the semiconductor wafer and the adhesive layer, thereby making separation of the pressure-sensitive adhesive sheet from the semiconductor wafer easier. However, similar studies by the inventors by using arbitrarily chosen materials showed that the pressure-sensitive adhesive sheet after heating was separated only with difficulty and the adherend could be fractured for example by folding thereof on the semiconductor wafer surface, for example because the shrinkable film shrank from multiple directions. Thus, there is currently no back grinding tape for protection of semiconductor wafers, for example from fracture during back grinding of semiconductor wafers, that can be separated without fracture or contamination of the semiconductor wafer when unneeded any more after back grinding, and also no separating device for separating the back grinding tape without fracture and contamination of semiconductor wafers.

Patent Document 1: Japanese Unexamined Patent Application No. 2000-129223

### Disclosure of the Invention

### Problems to be Solved by the Invention

The inventors considered that a pressure sensitive adhesive sheet having an added function of facile separability is needed to solve the problems above. In manual operation for separating a pressure sensitive adhesive sheet from an adherend, the tape is first peeled off at the terminal of the adherend to make a peeling initiation point, and then, the entire tape is pulled for separation. However, when a fragile adherend is used, instead of peeling off the tape, the peeling initiation point is made as the tape is pulled in the direction of the surface, i.e., as the peel angle is made as large as possible, to minimize the peel stress. It is possible to separate the pressure sensitive adhesive sheet from a fragile adherend by peeling of the tape at a peel angle kept as large as possible.

The inventors considered that it would be possible to provide an desired pressure sensitive adhesive tape, if the pressure sensitive adhesive tape can be deformed into a roll shape, similar to wound carpet roll (hereinafter, referred to as "tubular roll") after separation, during processing for facile separability by stimulation for example with heat. It is because separation together with such deformation is equivalent to separation at a peel angle as large as possible, and therefore the peel stress to the adherend is minimized. In other words, it is possible to minimize the risk of the fracture of fragile adherends.

In addition, the smaller peel stress leads to decrease of the risk of the adhesive being peeled off by the adherend and thus, to decrease of the possibility of the adherend being contaminated after separation. Even if the pressure sensitive adhesive tape adheres to the side of wafer polishing face, there is smaller risk of fracturing the semiconductor wafer because the peel stress can be minimized. The inventors have found a pressure sensitive adhesive sheet prepared by using a thermally shrinkable base, wherein an external edge region of the pressure sensitive adhesive sheet is floated locally from the wafer surface and separated as it curls unidirectionally automatically into a tubular roll (curling), by making a device to convert the shrinkage force applied to the thermally contacting base by heating to its couple of force. However, the pressure sensitive adhesive sheet has a property to curl only in a particular direction, and when a terminal of the pressure sensitive adhesive sheet in the direction perpendicular to the heat shrinkage direction is heated, the pressure sensitive adhesive sheet cannot curl automatically into a tubular roll (curling) and cannot be separated from the semiconductor wafer. Thus, a direction of heat treatment of the pressure sensitive adhesive sheet is restricted. Thus, the direction of the pressure sensitive adhesive sheet bonded to the semiconductor wafer should be adjusted properly according to the position of the heating means in the pressure sensitive adhesive sheet-separating device. Specifically, the pressure sensitive adhesive sheet should be bonded to the semiconductor wafer in a particular direction and unfavorably, there remained a problem that the pressure sensitive adhesive sheet may not be separated smoothly, depending on the configuration of the pressure sensitive adhesive sheet-bonding device or the pressure sensitive adhesive sheet-separating device.

Thus, an object of the present invention is to provide a pressure sensitive adhesive sheet that can be separated and recovered smoothly, if bonded to an adherend such as semiconductor wafer in any direction, and a resin laminate for use in the pressure sensitive adhesive sheet. Another object of the present invention is to provide a method for working an adherend using the pressure sensitive adhesive sheet according to the present invention, and a device for separating a pressure sensitive adhesive sheet for use in the adherend processing.

### Means to Solve the Problems

After intensive studies to solve the problems above, the inventors have found that a resin laminate which is prepared by laminating a particular high thermally shrinkable base layer and a low thermally shrinkable base layer via a self-adhesive layer, that can curl smoothly to form a tubular roll independently of the heating direction, i.e., even if a terminal of the resin laminate is heated from any one direction. Specifically, they have found that the resin laminate, which is prepared by using a substrate having a biaxial shrinking property as the thermally shrinkable base for the high thermally shrinkable base layer relatively larger in shrinkage ratio, and laminating the high thermally shrinkable base layer and a low thermally shrinkable base layer relatively smaller in shrinkage ratio via a particular self-adhesive layer, bends itself toward the high thermally shrinkable base layer side by heating from any one direction under the shrinkage stress generated in combination of those generated not only in two perpendicular directions but practically in two shrinkage axes, and curls automatically to form the tubular roll by further heating. They have further found that when a pressure sensitive adhesive sheet having the resin laminate is used as a tape for temporary fixation of an adherend such as semiconductor wafer, even if it is bonded to the adherend such as semiconductor wafer in any direction, the pressure sensitive adhesive sheet can be separated easily when unneeded any more, as a terminal of pressure sensitive adhesive sheet is heated from any one direction, i.e., independently of the direction of heating, and the separated pressure sensitive adhesive sheet can be recovered easily, and made the present invention.

Specifically, the present invention provides a resin laminate which bends toward the high thermally shrinkable base layer side when a terminal of the resin laminate is heated from any one direction and can automatically curl in one direction from one terminal to form a tubular roll by further heating comprising the high thermally shrinkable base layer having relatively high thermal shrinkage ratio and having a ratio (A:B) of the thermal shrinkage ratio in a main shrinkage direction [A (%)] to the shrinkage ratio in a direction perpendicular to the main shrinkage direction [B (%)] of 1:1 to 10:1, the low thermally shrinkable base layer having relatively low thermal shrinkage ratio, the high and low thermally shrinkable base layers bonded to each other via the self-adhesive layer, and a self-adhesive layer.

The resin laminate preferably includes a high thermally shrinkable base layer having a shrinking ratio of 5% or more in two axial directions perpendicular to each other when heated at a particular temperature in the range of 60 to 180°C, and the low thermally shrinkable base layer having a heat shrinkage ratio of less than 1% at the same temperature. The rigidity (product of shear elastic modulus and thickness) of the self-adhesive layer at 80°C is preferably 1 to 10³ N/m, and the self-adhesive layer preferably contains (is preferably made of) an acrylic polymer, and more preferably an active energy ray-curable adhesive layer. In addition, the active energy ray-curable adhesive layer preferably contains a side-cliain acrylate-containing acrylic polymer, a crosslinking agent, and an ultraviolet ray/active energy ray polymerization initiator.

A product of the Young's modulus and the thickness of the low thermally shrinkable base layer at 80°C is preferably 3×10⁵ N/m or less.

The present invention also provides a pressure sensitive adhesive sheet, including the resin laminate and an adhesive layer formed on the low thermally shrinkable base layer thereof. The adhesive layer preferably contains beads of glass or resin.

The present invention also provides a method for working an adherend, characterized by bonding the pressure sensitive adhesive sheet to an adherend, working (processing) the adherend in a desired manner, bending the pressure sensitive adhesive sheet toward the high thermally shrinkable base layer side to be locally floated from the adherend by heating a terminal of the pressure sensitive adhesive sheet from any one direction, and separating the pressure sensitive adhesive sheet. The pressure sensitive adhesive sheet for use is a pressure sensitive adhesive sheet having an active energy ray-curable adhesive layer as the self-adhesive layer. Preferably, the pressure sensitive adhesive sheet is bonded to the adherend, the adherend is worked (processed) in a desired manner, the self-adhesive layer is cured by irradiation of active-energy ray, and then, the pressure sensitive adhesive sheet is bent toward the high thermally shrinkable base layer side to be locally floated from the adherend by heating the terminal of the pressure sensitive adhesive sheet from any one direction. In addition, the pressure sensitive adhesive sheet is preferably separated, while a release tape bonded to an external edge surface region in the high thermally shrinkable base layer side of the deformed pressure sensitive adhesive sheet is pulled upward.

The invention also provides a device for separating the pressure sensitive adhesive sheet for use in the method of working an adherend, including heating means of heating the pressure sensitive adhesive sheet bonded to the adherend, and separating means of separating the pressure sensitive adhesive sheet bent toward the high thermally shrinkable base layer side and locally floated from the adherend by heating.

The device for separating the pressure sensitive adhesive sheet is preferably a pressure sensitive adhesive sheet-separating device, further including a suction hot stage for fixing and heating the adherend to which the pressure sensitive adhesive sheet is bonded, and a release tape, for peel separation, bonded to the external edge surface region in the high thermally shrinkable base layer side of the pressure sensitive adhesive sheet; a pressure sensitive adhesive sheet-separating device, further comprising a suction stage for fixing the pressure sensitive adhesive sheet-bonded adherend, a heat gun, and a release tape for peel separation, as it is bonded to the external edge surface region in the high thermally shrinkable base layer side of the pressure sensitive adhesive sheet; a pressure sensitive adhesive sheet-separating device, further including a suction stage for fixingthe pressure sensitive adhesive sheet-bonded adherend, and a internally-heated release tape-bonding mechanism for heating separation of the pressure sensitive adhesive sheet; or a pressure sensitive adhesive sheet-separating device, further including a suction stage for fixing the pressure sensitive adhesive sheet-bonded adherend and a movable heat source equipped with a mechanism for conveying the adherend from one terminal to the other terminal. In addition, the pressure sensitive adhesive sheet-separating device preferably contains additionally an active-energy ray source for curing the self-adhesive layer by irradiation of the pressure sensitive adhesive sheet having an active energy ray-curable adhesive layer with active-energy ray, and the active-energy ray source is preferably an ultraviolet ray irradiation source.

### Advantageous Effects of the Invention

When a pressure sensitive adhesive sheet having the resin laminate according to the present invention is used as the back grinding tape, it is possible to polish an adherend such as semiconductor wafer to a thickness of as small as approximately 20 µm to 25 µm without generation of fracture or chipping. Further, the pressure sensitive adhesive sheet according to the present invention bends toward the high thermally shrinkable base layer side when the polished wafer is heated from any one direction, and curls automatically to form a tubular roll by further heating. Thus, it is possible to separate the unneeded pressure sensitive adhesive sheet easily and completely, without difficulty of separation due to deposition of the pressure sensitive adhesive sheet, as folded, on the semiconductor wafer surface after heating. In addition, the direction of bonding when the sheet is bonded to the adherend such as semiconductor wafer is not limited, and the pressure sensitive adhesive sheet bonded in any direction can be separated smoothly from the adherend such as semiconductor wafer. Further, the pressure sensitive adhesive sheet according to the present invention can be separated and recovered smoothly after active-energy ray irradiation and heating steps in the device for separating the pressure sensitive adhesive sheet according to the present invention without facture of the adherend such as semiconductor wafer.

### Brief Description of the Drawings

Figure 1 is a schematic sectional view illustrating an example of a pressure sensitive adhesive sheet according to the present invention.
Figure 2 is a diagram (perspective view) illustrating automatic curling of the pressure sensitive adhesive sheet according to the present invention.
Figure 3 is a schematic side view illustrating an example of a separating device according to the present invention.
Figure 4 is side and top views illustrating a state when the pressure sensitive adhesive sheet according to the present invention is bonded to an adherend.

### Explanation of References

- 1:: High thermally shrinkable base layer
- 2:: Self-adhesive layer
- 3:: Low thermally shrinkable base layer
- 4:: Adhesive layer
- 5:: Pressure sensitive adhesive sheet
- 6:: Heating means
- 7:: Suction stage
- 8:: Release tape for recovering pressure sensitive adhesive sheet
- 9:: Ring frame
- 10:: Semiconductor wafer
- 11:: Pressure sensitive adhesive sheet (dicing tape)
- 12:: Main shrinkage direction of high thermally shrinkable base layer
- 13:: V notch

### Best Mode for Carrying Out the Invention

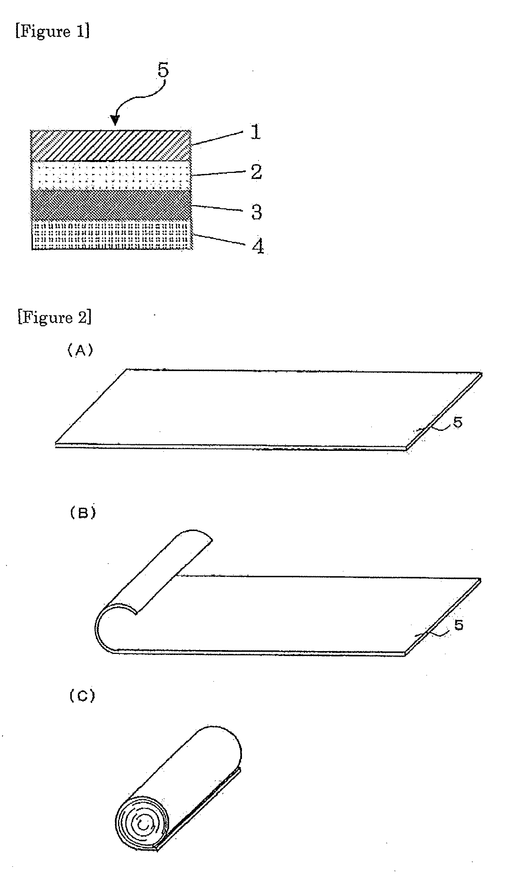

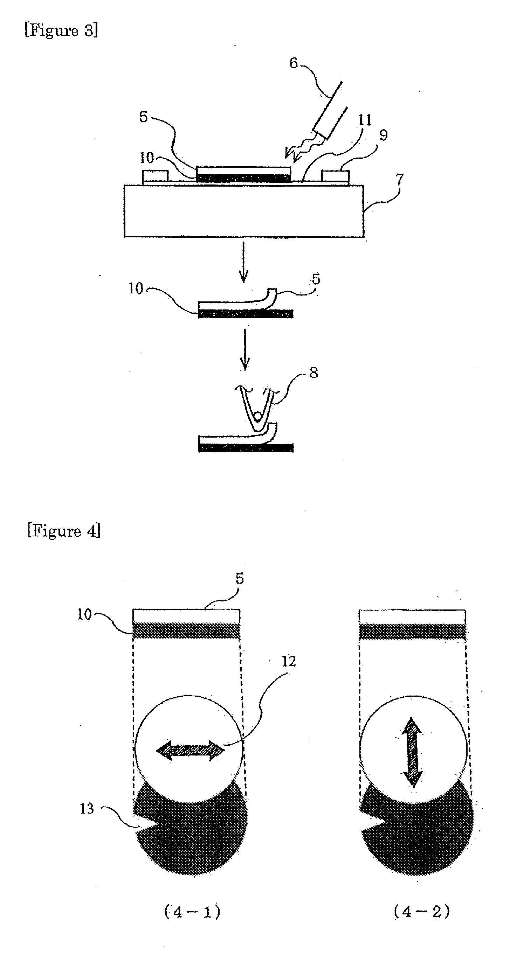

Hereinafter, preferred embodiments of the present invention will be described in detail with reference to drawings as needed. Figure 1 is a schematic sectional view illustrating an example of a pressure sensitive (pressure-sensitive) adhesive sheet (pressure sensitive adhesive tape) according to the present invention, and Figure 2 is a diagram (perspective view) illustrating the pressure sensitive adhesive sheet according to the present invention during automatic curling. Figure 3 is a schematic side view illustrating an example of a device for separating the pressure sensitive adhesive sheet according to the present invention, and Figure 4 is side and top views illustrating a state when the pressure sensitive adhesive sheet according to the present invention is bonded to an adherend.

In the example of Figure 1, a pressure sensitive adhesive sheet 5 according to the present invention has a high thermally shrinkable base layer (high thermally shrinkable contracting base layer) 1 having relatively high thermal shrinkage ratio and a low thermally shrinkable base layer (low thermally shrinkable contracting base layer) 3 having relatively low thermal shrinkage ratio bonded to each other via a self-adhesive layer 2 and - additionally, an adhesive layer 4 laminated on the low thermally shrinkable base layer 3.

In the examples of Figure 2, Figure (A) is a diagram illustrating the pressure sensitive adhesive sheet 5 before heating; Figure (B) is a diagram showing the state when the pressure sensitive adhesive sheet 5 heated from one direction (pressure sensitive adhesive sheet 5 after the adhesive power of the adhesive layer decreased or disappeared) starts automatic curling unidirectionally from the sheet external edge region; and Figure (C) is a diagram illustrating a tubular roll obtained after automatic curling of the pressure sensitive adhesive sheet 5. Although the pressure sensitive adhesive sheet 5 is circular in shape in this example, the shape is not limited thereto and may be selected properly according to application, and the shape may be, for example, quadrangular, elliptic, polygonal, or the like.

In the example of Figure 3, the separating device according to the present invention has heating means 6, a suction stage 7, and a release tape 8 for recovery of the pressure sensitive adhesive sheet 5, and the pressure sensitive adhesive sheet 5 is bonded to a semiconductor wafer 10 adhered to a pressure sensitive adhesive sheet (dicing tape) 11 fixed by a ring frame 9 on the suction stage 7. The pressure sensitive adhesive sheet 5 that is floated (lifted up) from the semiconductor wafer 10, as it is heated by the heating means 6, is separated from the semiconductor wafer 10, as it is bonded to the release tape 8 and peel-separated together with the release tape 8.

Figure 4-1 is side and top views of the pressure sensitive adhesive sheet 5 according to the present invention and a semiconductor wafer 10, in which a main shrinkage direction 12 of the high thermally shrinkable base layer in the pressure sensitive adhesive sheet 5 according to the present invention is in parallel with a V notch 13 of the semiconductor wafer 10, and Figure 4-2 is side and top views of the pressure sensitive adhesive sheet 5 according to the present invention and a semiconductor wafer 10, in which the main shrinkage direction 12 of the high thermally shrinkable base layer in the pressure sensitive adhesive sheet 5 according to the present invention is perpendicular to the V notch 13 of the semiconductor wafer 10.

### [Resin laminate]

The resin laminate according to the present invention has at least a high thermally-shrinkable base layer having relatively high thermal shrinkage ratio, a low thermally shrinkable base layer having relatively low thermal shrinkage ratio and a self-adhesive layer bonding the high and low thermally shrinkable base layers to each other, and is **characterized in that** the ratio (A:B) of the shrinkage ratio [A(%)] of the high thermally shrinkable base layer in the main shrinkage direction to the shrinkage ratio [B (%)] in the direction perpendicular to the main shrinkage direction is 1:1 to 10:1, and the resin laminate bends toward the high thermally shrinkable base layer side when a terminal of the resin laminate is heated from any one direction and can automatically curl in one direction (unidirectionally) from one terminal to form a tubular roll by further heating. In the example of Figure 1, a laminate of a high thermally shrinkable base layer 1, a self-adhesive layer 2, and a low thermally shrinkable base layer 3 is equivalent to the resin laminate according to the present invention.

### [High thermally shrinkable base layer]

The high thermally shrinkable base layer according to the present invention provides a driving force when the resin laminate having the high thermally shrinkable base layer bends toward the high thermally shrinkable base layer side when heated form any one direction and automatically curls from one terminal unidirectionally to form a tubular roll by further heating, and the direction of heating is arbitrary. For that reason, in the present invention, it is characterized that a high thermally shrinkable base which is biaxially shrinkable (a property of shrinking in two axial directions perpendicular) is used. The ratio (A:B) of the shrinkage ratio [A (%)] in the main shrinkage direction to the shrinkage ratio [B (%)] in the direction perpendicular to the main shrinkage direction is preferably 1:1 to 10:1, more preferably 1:1 to 5:1, and particularly preferably 1.:1 to 3:1. When the shrinkage ratio [B (%)] in the direction perpendicular to the main shrinkage direction is less than 1/10 of the shrinkage ratio [A (%)] in the main shrinkage direction, the laminate is insufficient in biaxial shrinkable efficiency, and shrinks only in the main shrinkage direction and curl unidirectional to form a tubular roll only when heated from a certain direction, whereby the heating direction is unfavorably restricted in this way. In the present invention, because the high thermally shrinkable base layer is biaxially shrinkable and thus the shrinkage stress is generated not only in the directions perpendicular to each other but also in combination of those formed by the two shrinkage axes, the shrinkage stress can provide the driving force to make the resin laminate having the high thermally shrinkable base layer shrink and automatically curl to form a tubular roll when the high thermally shrinkable base layer is heated in any direction.

The biaxial shrinkage ratio of the high thermally shrinkable base layer according to the present invention is 5% or more (preferably e.g., 5 to 80%), and more preferably 15% or more (for example, 15 to 80%) in each of the two directions at a particular temperature (e.g., 80°C) in the range of 60 to 180°C. Since the rigidity of the entire pressure sensitive adhesive sheet is larger than the shrinkage stress if the shrinkage ratio is less than 5% in each of the two directions, the resin laminate having the high thermally shrinkable base layer does not bend toward the high thermally shrinkable base layer side or bends only slightly when heated in any one direction, possibly prohibiting formation of the tubular roll by smooth curling. However, the shrinkage ratios respectively in the two directions may be the same as or different from each other, for example, the shrinkage in one axis may be 20% and that in the other axis may be 30%, and in this case, the axial direction higher in shrinkage ratio is the main shrinkage direction.

The biaxial shrinkage efficiency of the high thermally shrinkable base layer according to the present invention can be provided, for example, by biaxially stretching a film extruded from an extruder, and the shrinkage ratio can be adjusted by the degree of stretching. The high thermally shrinkable base constituting the high thermally shrinkable base layer according to the present invention is preferably a material having sufficient shrinkage to cause automatic curling of the resin laminate having the high thermally shrinkable base by heating with heating means of the separating device. As will be described below, when an active energy ray-curable adhesive layer is used as the self-adhesive layer bonding the high- and low-thermally shrinkable bases to each other, and also as the adhesive layer formed on the low thermally shrinkable base layer; and the active-energy ray is irradiated through the high thermally shrinkable base layer, the high thermally shrinkable base layer is preferably a material allowing transmission of the active-energy ray in an amount of more than a predetermined value (for example, transparent resin).

Preferable examples of the high thermally shrinkable bases for the high thermally shrinkable base layer according to the present invention include polyolefins such as polypropylene and polyethylene; polyesters such as polyethylene terephthalate, polybutylene terephthalate, and polylactates polyimides such as Kapton; polyamides such as 6,6-nylon; polyether sulfonates; ultraviolet ray-transmitting polymers such as polynorbornene; and the like. The material can be selected properly from these polymers according to the separation environment such as heating condition, and these polymers may be used alone or as a mixture of two or more.

In particular, the high thermally shrinkable base layer according to the present invention is preferably a polyester-based high thermally shrinkable base layer. It is, for example, because it is superior in economic efficiency such as cost, higher in adhesiveness to the self-adhesive layer used for bonding to the low thermally shrinkable base layer described below, and faster in response to shrinkage initiation temperature.

Examples of the high thermally shrinkable base layer according to the present invention include commercial products such as "SPACECLEAN" (trade name, manufactured by TOYOBO CO., LTD. CO., LTD.), "Fancy Wrap" (trade name, manufactured by GUNZE Limited), "TORAYFAN" (trade name, manufactured by Toray Industries Inc.), "LUMIRROR" (trade name, manufactured by Toray Industries Inc.), "RTON" (trade name, manufactured by JSR Corporation) and "ZEONOR" (trade name, manufactured by ZEON CORPORATION), and in particular, "SPACECLEAN" (trade name, manufactured by TOYOBO CO., LTD. CO., LTD.) can be used preferably because it satisfies all of the requirements above and has high shrinkage ratio additionally. These commercial products may be stretched or crosslinked as needed, or the surface thereof may be subjected to corona treatment or printing-processed. The commercial product may be converted into a base further higher in shrinkage ratio by such a stretching treatment.

A thickness of the high thermally shrinkable base layer according to the present invention is preferably, for example, 5 to 300 µm, and more preferably 10 to 100 µm. A thickness of less than 5 µm unfavorably leads to deterioration in productivity such as difficulty in film winding processability and operability during production, while a thickness of more than 300 µm leads to deterioration in economic efficiency and also increase in rigidity, prohibiting automatic curling and causing separation between the high thermally shrinkable base layer and the self-adhesive layer, which may in turn lead to rupture of the laminate. In addition, large rigidity often results in residual of the stress when the pressure sensitive adhesive sheet is bonded and generation of larger elastic deforming force, often leading to increase in warpage of the adherend such as semiconductor wafer when it is polished thinly.

When used in a laminate with a low thermally shrinkable base layer, the high thermally shrinkable base layer according to the present invention can provide a driving force for bending the laminate toward the high thermally shrinkable base layer side by heating in the arbitral on direction, and forming a tubular roll by automatic curling unidirectionally from one terminal by further heating, and when a pressure sensitive adhesive sheet having the high thermally shrinkable base layer is used, for example as a back grinding tape of semiconductor wafer, it is not needed to bond the pressure sensitive adhesive sheet to the semiconductor wafer by taking the winding direction into consideration, and even when bonded in any direction, the pressure sensitive adhesive sheet can curl smoothly by heating in any one direction, forming a tubular roll.

### [Low thermally shrinkable base layer]

The low thermally shrinkable base layer according to the present invention has a function to provide the laminate of the high- and low thermally shrinkable base layers with a force of reaction to the shrinkage stress of the high thermally shrinkable base layer and thus, a force of couple needed for curling. It also has a function to prevent fracture of the adherend such as semiconductor wafer, as it shrinks by heating as it is bonded to the adherend such as semiconductor wafer. Thus, the low thermally shrinkable base layer according to the present invention preferably has a low thermal shrinkage ratio during heating separation. Specifically, the thermal shrinkage ratio is preferably less than 1% (preferably 0.5% or less) at a particular temperature in the range of 60 to 180°C (temperature at which the high thermally shrinkable base layer shrinks by 5% or more in two axis directions), for example at 80°C, and the low thermally shrinkable base layer may expand when the high thermally shrinkable base layer shrinks. Namely, the coefficient of thermal expansion of the low thermally shrinkable base layer may be a negative value. The minimum value of the thermal shrinkage ratio of the low thermally shrinkable base layer is, for example, approximately -1%. The product of the Young's modulus and the thickness of the low thermally shrinkable base layer at the separation temperature (e.g., 80°C) is 3×10⁵ N/m or less (for example, 1.0×10² to 3.0×05 N/m), more preferably 2.8×10⁵ N/m or less (for example, 1.0×10³ to 2.8×10⁵ N/m). When the product of Young's modulus and the thickness is more than 3×10⁵ N/m, the layer becomes excessively rigid, prohibiting formation of the tubular roll and possibly making the separation by heating difficult.

When operability during production, convenience in handling and economic efficiency are considered, the Young's modulus of the low thermally shrinkable base layer according to the present invention at the separation temperature (e.g., 80°C) is preferably 3×10⁶ to 2×10¹⁰ N/m², more preferably 1×10⁸ to 1×10¹⁰ N/m². When the Young's modulus is too small, warpage of the semiconductor wafer after grinding becomes larger, possibly causing troubles for example in conveyance. Alternatively when the Young's modulus is too large, the resin laminate may not show automatic curling. The thickness of the low thermally shrinkable base layer is preferably less than 100 µm (e.g., approximately 5 to 100 µm), and more preferably approximately 10 to 75 µm. Excessively larger thickness is unfavorable because automatic curling efficiency, handling efficiency and also economic efficiency are deteriorated. As will be described below, when the self-adhesive layer bonding to the high- and low thermally shrinkable bases and the adhesive layer formed on the low thermally shrinkable base layer are active energy ray-curable adhesive layers, similarly to the high thermally shrinkable base layer, the layers should contain (be made of) an active-energy ray-transmitting material (for example, transparent resin).

Examples of the low-thermally shrinkable bases for the low thermally shrinkable base layer according to the present invention include polyolefins such as polypropylene and polyethylene; polyesters such as polyethylene terephthalate, polybutylene terephthalate, and polylactates; polyimides such as Kapton; polyamides such as 6,6-nylon; polyether sulfonates; ultraviolet ray-transmitting polymers such as polynorbornene; and the like. The material can be selected properly from these polymers according to the separation environment such as heating condition, and these polymers may be used alone or as a mixture of two or more.

The low thermally shrinkable base layer according to the present invention is preferably a polyester-based low thermally shrinkable base layer, in particular, a polyethylene terephthalate-based low thermally shrinkable base layer, among the layers above. It is because such a layer has advantages, for example, that it is superior in economic efficiency such as cost effectiveness and tackiness to the self-adhesive layer used for bonding to the high thermally shrinkable base layer, and also superior in thermal stability and mechanical strength.

Examples of the low thermally shrinkable base layers according to the present invention include commercial products such as "TORAYFAN " (trade name, manufactured by Toray Industries Inc.), " LUMIRROR " (trade name, manufactured by Toray Industries Inc.), "ARTON" (trade name, manufactured by JSR Corporation), "ZEONOR" (trade name, manufactured by ZEON CORPORATION) and "Melinex" (trade name, manufactured by Teijin DuPont Films Japan Limited), and in particular, "LUMIRROR" (trade name, manufactured by Toray Industries Inc.) and "Melinex" (trade name, manufactured by Teijin DuPont Films Japan Limited) can be used preferably. The commercial products may be stretched or crosslinked as needed, or the surface thereof may be subjected to corona treatment or printing process.

The low thermally shrinkable base layer according to the present invention, when used in the laminate with the high thermally shrinkable base layer, has a function to prevent fracture of the adherend such as semiconductor wafer by shrinkage of the laminate by heating, as it is bonded to the adherend, as it resists the shrinkage stress of the high thermally shrinkable base layer, and additionally, the reaction force caused by resistance to the shrinkage stress of the high thermally shrinkable base layer has a function to accelerate deformation of the base preferable for automatic curling by converting the shrinkage stress to force of couple.

### [Self-adhesive layer]

The self-adhesive layer according to the present invention preferably has a self-adhesive strength (or adhesive strength) sufficient for bonding the high thermally shrinkable base layer to the low thermally shrinkable base layer. In addition, when the pressure sensitive adhesive sheet according to the present invention having a high thermally shrinkable base layer, a low thermally shrinkable base layer, and a self-adhesive layer bonding the high and low thermally shrinkable base layers to each other is used as a back grinding tape of an adherend such as semiconductor wafer, the self-adhesive layer is preferably flexible for smooth adhesion and smooth tape-cutting operation after adhesion. On the other hand for heat-separation of the pressure sensitive adhesive sheet, the self-adhesive layer is preferably rigid enough to be resistant to shrinkage deformation as much as possible to transmit the shrinkage stress of the high thermally shrinkable base layer to the low thermally shrinkable base layer and also to prevent the pressure sensitive adhesive sheet after heating from being hardly separable, as it is folded on the surface of the adherend such as semiconductor wafe. Thus, a self-adhesive layer having a function to control flexibility or rigidity is preferable.

The self-adhesive strength of the self-adhesive layer according to the present invention to the high- and low thermally shrinkable base layers (peel separation at 180°, to silicon mirror wafer, tensil speed: 300 mm/minute) is preferably, for example, 4 N/10 mm or more, more preferably 6 N/10 mm or more, and particularly preferably 8 N/10 mm or more. The flexibility (or the rigidity) of the self-adhesive layer according to the present invention (thickness: 5 µm), which can be expressed by shear elastic modulusxthickness, is preferably 1 to 1×10³ N/m at the heat-separating temperature, for example, of 80°C. If the rigidity of the self-adhesive layer when heated to 80°C is lower than 1 N/m, it is not possible to transmit the shrinkage stress of the high thermally shrinkable base layer to the low thermally shrinkable base layer, and the adhesive layer deforms as it is pulled by shrinkage of the high thermally shrinkable base layer, consequently prohibiting spontaneous curling. On the other hand, if the rigidity of the self-adhesive layer when heated to 80°C is more than 1×10³ N/m, the adhesive power becomes generally insufficient, possibly causing separation between the high thermally shrinkable base layer and the self-adhesive layer, and rupture of the laminate. In addition, the rigidity becomes so large that the pressure sensitive adhesive sheet having the self-adhesive layer deforms, instead of automatic curling, raising a concern for example about rupture of the adherend by the stress.

For the reasons above, the self-adhesive layer according to the present invention is preferably a layer of which the rigidity can be modified between before and after separation. For example if an active energy ray-curable adhesive is used as the adhesive for the self-adhesive layer, it is possible to make flexibility and adhesive power higher in the state before irradiation of the active-energy ray and raise rigidity after irradiation of the active-energy ray. Thus the rigidity can be modified easily as needed. In the present invention, the active-energy ray is, for example, ultraviolet ray, visible ray, infrared ray, radiation ray, electron beam, or the like.

Examples of the adhesives for the self-adhesive layer according to the present invention include known adhesives such as rubber-based adhesives, acrylic adhesives, vinyl alkylether-based adhesives, silicone-based adhesives, polyester-based adhesives, polyamide-based adhesives, urethane-based adhesives, styrene-diene block copolymer-based adhesives, and creep property-improved adhesives in blend of one of these adhesives, and a hot-melt resin having a melting point of approximately 200°C or lower, and these adhesives may be used alone or in combination of two or more (see, for example, JP 56-61468A, 61-174857A, 63-17981A, and 56-13040A). The adhesive may contain, in addition to the adhesive component (base polymer), suitable additives including crosslinking agents (such as polyisocyanates, alkyletherified-melamine compounds, and the like), tackifiers (such as rosin-derived resins, polyterpene resins, petroleum resins, oil-soluble phenol resins, and the like), plasticizers, fillers, aging inhibitors, and others. Alternatively, beads of glass or resin may be added. Addition of the beads of glass or resin is advantageous in controlling adhesion properties and shear elastic modulus easily.

The adhesives generally used include rubber-based adhesives containing a natural rubber or various synthetic rubbers as the base polymer; acrylic adhesives containing, as the base polymer, an acrylic polymer (homopolymer or copolymer) prepared by using, as monomer components, one or more alkyl (meth)acrylates (e.g., C₁₋₂₀ alkyl esters such as methyl ester, ethyl ester, propyl ester, isopropyl ester, butyl ester, isobutyl ester, s-butyl ester, t-butyl ester, pentyl ester, hexyl ester, heptyl ester, octyl ester, 2-hydroxyethyl ester, 2-ethylhexyl ester, isooctyl ester, isodecyl ester, dodecyl ester, tridecyl ester, pentadecyl ester, hexadecyl ester, heptadecyl ester, octadecyl ester, nonadecyl ester, and eicosyl ester), and the like.

The acrylic polymer may have a unit corresponding to other monomer component copolymerizable with the alkyl(meth)acrylate ester as needed, for modification of cohesive power, heat resistance, crosslinking efficiency, and others. Examples of the monomer components include monomers having a carboxyl group such as acrylic acid, methacrylic acid, carboxyethyl acrylate, carboxypentyl acrylate, itaconic acid, maleic acid, fumaric acid, or crotonic acid; acid anhydride monomers such as maleic anhydride and itaconic anhydride; hydroxyl group-containing monomers such as hydroxyethyl (meth)acrylate, hydroxypropyl (meth)acrylate, hydroxybutyl (meth)acrylate, hydroxyhexyl (meth)acrylate, hydroxyoctyl (meth)acrylate, hydroxydecyl (meth)acrylate, hydroxylauryl (meth)acrylate, and (4-hydroxymethylcyclohexyl)methyl methacrylate; sulfonic acid group-containing monomers such as styrenesulfonic acid, allylsulfonic acid, 2-(meth)acrylamido-2-methylpropanesulfonic acid, (meth)acrylamido-propanesulfonic acid, sulfopropyl (meth)acrylate, and (meth)acryloyloxynaphthalenesulfonic acid; (N-substituted) amide-based monomers such as (meth)acrylamide, N,N-dimethyl(meth)acrylamide, N-butyl(meth)acrylamide, N-methylol (meth)acrylamide, and N-methylolpropane (meth)acrylamide; aminoalkyl (meth)acrylate-based monomers such as aminoethyl (meth)acrylate, N,N-dimethylaminoethyl (meth)acrylate, and t-butylaminoethyl(meth)acrylate; alkoxyalkyl (meth)acrylate-based monomers such as methoxyethyl (meth)acrylate and ethoxyethyl (meth)acrylate; maleimide-based monomers such as N-cyclohexylmaleimide, N-isopropylmaleimide, N-laurylmaleimide, and N-phonymaleimide; itaconimide-based monomers such as N-methylitaconimide, N-ethylitaconimide, N-butylitaconimide, N-octylitaconimide, N-2-ethylhexylitaconimide, N-cyclohexylitaconimide, and N-lauryhtaconimide; succinimide-based monomers such as N-(meth)acryloyloxymethylene succinimide, N-(meth)acryloyl-6-oxyhexamethylene succinimide, and N-(meth)acryloyl-8-oxyoctamethylene succinimide; vinyl monomers such as vinyl acetate, vinyl propionate, N-vinylpyrrolidone, methylvinylpyrrolidone, vinylpyridine, vinylpiperidone, vinylpyrimidine, vinylpiperazine, vinylpyrazine, vinylpyrrole, vinylimidazole, vinyloxazole, vinylmorpholine, N-vinylcarboxylic amides, styrene, α-methylstyrene and N-vinyleaprolactam; cyanoacrylate monomers such as acrylonitrile and methaerylonitrile; epoxy group-containing acrylic monomers such as glycidyl (meth)acrylate; glycol-based acryl ester monomers such as polyethylene glycol (meth)acrylate, polypropylene glycol (meth)acrylate, methoxyethylene glycol (meth)acrylate, and methoxypolypropylene glycol (meth)acrylate; acrylic ester-based monomers having for example heterocyclic rings, halogen atoms, silicon atoms or the like, such as tetrahydrofurfuryl (meth)acrylate, fluorine (meth)acrylate, and silicone (meth)acrylate; multifunctional monomers such as hexanediol di(meth)acrylate, (poly)ethylene glycol di(meth)acrylate, (poly)propylene glycol di(meth)acrylate, neopentylglycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy acrylates, polyester acrylates, and urethane acrylates; olefin monomers such as isoprene, butadiene, and isobutylene; vinyl ether-based monomers such as vinyl ethers; and the like. These monomer components may be used alone or in combination of two or more.

The acrylic copolymers can be prepared by polymerization of the monomer components above. The method of polymerizing the monomer components may be any conventional method, and is, for example, solution polymerization, emulsion polymerization, bulky polymerization, suspension polymerization, or the like.

The self-adhesive layer according to the present invention is preferably a self-adhesive layer of an active energy ray-curable acrylic adhesive, for adjustment of its rigidity as needed. The active energy ray-curable acrylic adhesive according to the present invention can be prepared, for example, by mixing a known active energy ray-curable compound with an acrylic adhesive. Preferable examples of the active energy ray-curable compounds include compounds having multiple functional groups having a carbon-carbon multiple bond such as vinyl, methacryl or acetylene in the molecule. The carbon-carbon multiple bond-containing functional groups present in these compounds generate radicals by cleavage of the bonds by active-energy ray irradiation and the radicals, which act as a crosslinking agent, initiates formation of a three-dimensional network structure. Favorable examples of the active energy ray-curing compounds for use include organic salts such as iodonium salts, phosphonium salts, antimonium salts, sulfonium salts and borate salts; and compounds having multiple heterocyclic rings, such as oxirane, oxetane, oxolane, thiirane, and aziridine, as functional groups. The compounds having multiple heterocyclic rings as functional groups generate ions by cleavage of organic salts by irradiation with active-energy ray, and the ions functioning as an initiator initiate ring-opening reaction of the heterocyclic rings, allowing formation of three-dimensional network structure.

In particular, the active energy ray-curable compound according to the present invention is preferably an active energy ray-curable compound having two or more functional groups having carbon-carbon double bonds, such as acrylate groups, in the molecule (see JP 2003-292916A). An acrylate group is preferable from the viewpoints of reactivity and processability because it is relatively more reactive to the active-energy ray and such an adhesive having acrylate groups can be selected from various acrylic adhesives. Examples of the active energy ray-curable compounds containing two or more carbon-carbon double bonds in the molecule include trimethylolpropane tri(meth)acrylate, pentaerythritol tri(meth)acrylate, pentaerythritol tetra(meth)acrylate, dipentaerythritol monohydroxy(meth)acrylate, dipentaerythritol hexa(meth)acrylate, 1,4-butylene glycol di(math)acrylate, tetraethylene glycol di(meth)acrylate, 1,6-hexanediol (meth)acrylate, neopentylglycol di(meth)acrylate, esters of (meth)acrylic acid with a polyvalent alcohol, ester acrylate oligomers, 2-propenyl-3-butenyl cyanurate, isocyanurate, isocyanurate compounds, and the like. These active energy ray-curable compounds can be used alone or as two or more of them are mixed.

The active energy ray-curable acrylic adhesive according to the present invention for use may be an acrylic adhesive having a base polymer provided with active energy ray-curable property. Examples of the acrylic adhesives having a base polymer provided with active energy ray-curable efficiency include acrylic adhesives having carbon-carbon double bond-containing functional groups and others bound to the side chains. The acrylic adhesive having, as the carbon-carbon double bond-containing functional groups, for example acrylate groups bound to the side chains can be prepared for example by binding an isocyanate compound such as acryloyloxyethyl isocyanate or methacryloyloxyethyl isocyanate to an acrylic polymer having hydroxyl groups bound to the side chains via urethane bonds. If an acrylic adhesive with active energy ray-curable efficiency is used as the base polymer constituting the self-adhesive layer, an active energy ray-curing compound may be added or may not be added separately. Since the self-adhesive layer of an acrylic adhesive containing a base polymer provided with active energy raycurable efficiency may contain no active energy ray-curable compound or the like, which is the low-molecular weight component, or may not contain it in a large amount, the active energy ray-curable compound and others do not migrate in the self-adhesive layer over time, thereby giving a self-adhesive layer having a stabilized layer structure.

The blending rate of the active energy ray-curable compound is not particularly limited, and is preferably, for example, approximately 0.5 to 200 weight parts, more preferably approximately 1 to 50 weight parts, with respect to 100 weight parts of the acrylic copolymer in the adhesive. When the blending rate of the active energy ray-curable compound is more than 200 weight parts with respect to 100 weight parts of the acrylic copolymer, the content of the low-molecular weight substance becomes too high, occasionally leading to deterioration in adhesive strength between the high and low thermally shrinkable base layers. Alternatively when the blending rate of the active energy ray-curable compound is less than 0.5 weight part with respect to 100 weight parts of the acrylic copolymer, it may be difficult to cause change in rigidity of the self-adhesive layer by irradiation with active-energy ray. The viscosity of the active energy ray-curable compound is not particularly limited.

The active energy ray-curable adhesive may contain an active energy ray polymerization initiator, which is blended for improvement in reaction rate for formation of the three-dimensional network structure. The active energy ray polymerization initiator can be selected properly from known commonly-used polymerization initiators according to the kind of the active-energy ray used (such as infrared ray, visible ray, ultraviolet ray, radiation ray, electron beam, or the like). Compounds initiating photopolymerization by irradiation of ultraviolet ray are preferable, form the viewpoint of productivity. Typical examples of the active energy ray polymerization initiators include, but are not limited to, ketone initiators such as benzophenone, acetophenone, quinone, naphthoquinone, anthraquinone, and fluorenone; azo initiators such as azobisisobutylonitrile; peroxide initiators such as benzoylperoxide, perbenzoic acid, and the like. Commercial products thereof include, for example, "Irgacure 184" and "Irgacure 651" (trade names, manufactured by Ciba-Geigy K.K.) and others.

These active energy ray polymerization initiators can be used alone or as a mixture of two or more. The amount of the active energy ray polymerization initiator is, for example, approximately 0.01 to 10 weight parts with respect to 100 weight parts of the acrylic copolymer constituting the adhesive. The active energy ray polymerization initiator may be used in combination with an active-energy ray polymerization accelerator, as needed.

The method for forming the self-adhesive layer according to the present invention for use may be any known commonly-used method, and examples thereof include a method of preparing a coating solution containing adhesives and others by using a solvent as needed, and applying the solution on a low thermally shrinkable base layer directly, and a method of coating the coating solution on a suitable separator (such as release paper) forming an self-adhesive layer and transferring (depositing) the layer onto a low thermally shrinkable shrinkage base layer. Such a transfer method may leave voids (pores) at the interface between the transferred self-adhesive layer and the low thermally shrinkable base layer. In such a case, the voids can be diffused and eliminated under heat and pressure for example by autoclave treatment. The self-adhesive layer may be a single layer or multiple layers.

The thickness of the self-adhesive layer according to the present invention is not particularly limited, but preferably in the range of 5 to 100 µm, more preferably in the range of 10 to 50 µm, from the viewpoints of deformation efficiency during production of the tubular roll by curling, economic efficiency, and simplicity of production operation. A thickness of lower than 5 µm leads to deterioration in accordance to the shrinkage of the high thermally shrinkable base layer and also in efficiency of stress relaxation. On the other hand, a thickness of more than 100 µm is unfavorable because it makes it difficult to form a tubular roll, which in turn leads to deterioration in handling efficiency and economic efficiency.

Since the self-adhesive layer according to the present invention is adhesive enough to bond the high and low thermally shrinkable base layers to each other before heating, and also flexible sufficiently, it can relax the stress generated when the pressure sensitive adhesive sheet is bonded to the adherend and reduce warpage of the adherend after processing. The layer gains suitable rigidity when the pressure sensitive adhesive sheet is separated under heat and can transfer the shrinkage stress of the high thermally shrinkable base layer to the low thermally shrinkable base layer. It is possible by transfer of the shrinkage stress of the high thermally shrinkable base layer to the low thermally shrinkable base layer to form a tubular roll by automatic curling of the pressure sensitive adhesive sheet in one direction.

### [Adhesive layer]

The pressure sensitive adhesive sheet according to the present invention has at least one layer of adhesive layer on the low thermally shrinkable base layer in the resin laminate. The adhesive layer preferably prevents fracture of the adherend during polishing, as it is bonded firmly to the adherend such as semiconductor wafer, in the step of polishing the adherend, and is separated easily from the adherend surface, as the adhesive power thereof is reduced significantly after the polishing step. The adhesive layer according to the present invention for use is, for example, an active energy ray-curable adhesive layer or a pressure-sensitive adhesive layer. When an active energy ray-curable adhesive layer is used as the adhesive layer, it is possible to reduce the adhesive power by irradiation with active-energy ray. Alternatively when a pressure-sensitive adhesive layer is used as the adhesive layer, it is possible to reduce the adhesive power under heat by using a pressure-sensitive adhesive layer obtained by adjusting the composition, additives and others. Beads of glass or resin are preferably added to the adhesive layer, in addition to the adhesive component (base polymer). It is possible to raise the shear elastic modulus and make it easier to reduce the adhesive power by addition of the beads of glass or resin. The adhesive layer according to the present invention may contain additionally suitable additives such as crosslinking agents (e.g., polyisocyanates, alkyletherified melamine compounds, etc.), tackifiers (e.g., rosin-derived resins, polyterpene resins, petroleum resins, oil-soluble phenol resins, etc.), plasticizers, thickeners, fillers, aging inhibitors, and others.

The active energy ray-curable adhesive layer used as the adhesive layer according to the present invention is preferably a layer having an adhesive power (peel separation at 180°, to silicon mirror wafer, tension speed: 300 mm/minute) for example of 0.1 N/10mm or more at room temperature (25°C) before active-energy ray irradiation, and an adhesive power (peel separation at 180°, to silicon mirror wafer, tension speed: 300 mm/minute) for example of 0.05 N/10 mm or less at room temperature (25°C) after active-energy ray irradiation by formation of three-dimensional network structure and accompanied increase in elasticity.

Examples of the active energy ray-curable adhesives constituting the active energy ray-curable adhesive layer used as the adhesive layer include those in the examples of the active energy ray-curable adhesives constituting the self-adhesive layer, and these monomer components may be used alone or as a mixture of two or more. The active energy ray-curable adhesive used as the adhesive layer can be prepared by polymerization of the monomer components, and an active energy ray-curable adhesive having a particular adhesive power can be prepared by adjustment of polymerization degree, weight-average molecular weight, and others.

The average diameter of the beads of glass or resin added to the adhesive layer is, for example, 1 to 100 µm, and preferably approximately 1 to 20 µm. The amount of the beads of glass or resin used is, for example, approximately 25 to 200 weight parts, and preferably 30 to 100 weight parts, with respect to 100 weight parts of the acrylic copolymer constituting the adhesive. Use of an excessively large amount of beads of glass or resin may lead to deterioration in adhesion properties, while use of an excessively small amount of the beads of glass or resin lead to deterioration of the advantageous effects above.

The active energy ray-curable adhesive may contain an active energy ray polymerization initiator blended therein, for improvement of the reaction rate of the three-dimensional network structure formation. The active energy ray polymerization initiator can be selected properly from known commonly-used polymerization initiators according to the kind of the active-energy ray used (e.g., infrared rays, visible ray, ultraviolet ray, radiation ray, electron beam, or the like). Compounds initiating photopolymerization by irradiation of ultraviolet ray are preferable form the viewpoint of productivity. Typical examples of the active energy ray polymerization initiators include the active energy ray polymerization initiators similar to those used for the self-adhesive layer, and the active energy ray polymerization initiators may be used alone or as a mixture of two or more.

The amount of the active energy ray polymerization initiator used is approximately 0.01 to 10 weight parts, with respect to 100 weight parts of the acrylic copolymer constituting the adhesive. The active energy ray polymerization initiator may be used in combination with an active-energy ray polymerization accelerator, as needed.

The thickness of the adhesive layer is not particularly limited, but is preferably in the range of 5 to 100 µm, more preferably in the range of 10 to 50 µm, from the viewpoints of economic efficiency and simplicity of production operation. A thickness of lower than 5 µm makes it difficult to hold and temporarily fix the adherend because of deficiency of adhesive power, while a thickness of more than 100 µm is uneconomical and inferior in handling efficiency, and thus, unfavorable.

The adhesive layer can be formed by a suitable method, for example, by a method (dry coating method) of coating a coating agent containing an adhesive layer-forming material such as the natural rubber, synthetic rubber, or rubber elastic synthetic resin described above on a low thermally shrinkable base layer, a method (dry lamination method) of coating the coating agent on a suitable separator (such as release paper) forming an adhesive layer thereon and transferring (depositing) it on a low thermally shrinkable base layer, a method (coextrusion method) of co-extruding a resin composition containing a material constituting the low thermal shrinkable base layer and a coating agent, or the like. Such a transfer method, if used, may leave voids (pores) at the interface between the transferred adhesive layer and the low thermally shrinkable base layer. In such a case, the voids can be diffused and eliminated under heat and pressure for example by autoclave treatment. The adhesive layer may be a single layer or multiple layers.

When the adhesive layer according to the present invention is used, the pressure sensitive adhesive sheet having the adhesive layer bonds to the adherend, such as semiconductor wafer, tightly in the step of polishing the adherend, thereby allowing desired processing according to applications without fracture of the adherend. It is possible, after the adherend-polishing step, to reduce the adhesive power and separate the pressure sensitive adhesive sheet easily from the adherend, by active-energy ray irradiation or heat treatment of the pressure sensitive adhesive sheet having the adhesive layer.

### [Pressure sensitive adhesive sheet]

The pressure sensitive adhesive sheet according to the present invention is prepared by laminating an adhesive layer additionally on the low thermally shrinkable base layer of a resin laminate having the high- and low thermally shrinkable base layers bonded to each other by a self-adhesive layer. The pressure sensitive adhesive sheet according to the present invention may be protected before use, as the surface of the adhesive layer is covered with a separator (separation liner). It may have additionally intermediate layers, such undercoat layer and self-adhesive layer, formed as needed.

The pressure sensitive adhesive sheet according to the present invention fixes an adherend such as semiconductor wafer, as bonded thereto, and allows desired processing of the adhered without fracture thereof during processing. It is also possible to control the warpage of the adherend after processing by relaxing the stress applied when the pressure sensitive adhesive sheet is bonded. Since the adhesive power of the adhesive layer declines and also the pressure sensitive adhesive sheet curls automatically from one terminal unidirectionally forming a tubular roll, as it is separated due to shrinkage of the high thermally shrinkable base layer, when heated from any one direction (after active-energy ray irradiation and subsequent heating if an active energy ray-curable adhesive layer is used as the adhesive layer), it is possible to remove the pressure sensitive adhesive sheet from the adherend surface quite easily without damage of the adherend and contamination of the adherend by imcomplete separation after desired processing on the adherend.

### [Separator]

The pressure sensitive adhesive sheet according to the present invention may have a separator (separation liner) formed on the adhesive layer surface, for protection of the adhesive layer and prevention of blocking. The separator is separated when the pressure sensitive adhesive sheet is bonded to an adherend. The separator for use is not particularly limited, and, for example, any commonly-used known release paper may be used. Examples thereof include bases having a release layer such as of plastic film or paper surface-treated with an release agent such as a silicone-, long-chain alkyl-, fluorine- or molybdenum sulfide-based release agent; less adhesive bases of a fluorochemical polymer such as of polytetrafluoroethylene, polychloro-trifluoroethylene, polyvinyl fluoride, polyvinylidene fluoride, a tetrafluoroethylene-hexafluoropropylene copolymer, or a chlorofluoroethylene-vinylidene fluoride copolymer; less adhesive bases of a nonpolar polymer such as an olefinic resin (such as polyethylene and polypropylene); and the like.

### [Method of working adherend]

The pressure sensitive adhesive sheet according to the present invention is used, for example as a pressure sensitive adhesive sheet for temporary fixation during processing of an adherend. Examples of the adherends include semiconductor wafers such as of silicon, gallium-arsenic and others, semiconductor packages, glass, ceramics, and the like. Examples of the workings of the adherend include grinding, cutting, polishing, etching, lathe turning, heating (only at a temperature not higher than the heat shrinkage initiation temperature of the high thermally shrinkable base layer), and the like, and the working is not particularly limited, if it is a working that is applicable to the pressure sensitive adhesive sheet. The pressure sensitive adhesive sheet according to the present invention, which is bonded to the surface of an adherend such as semiconductor wafer, has a function to protect the semiconductor wafer surface from the stress, grinding water, and grinding dust (silicon dust) that are applied thereto when the adherend temporarily fixed by the pressure sensitive adhesive sheet is worked for example by polishing. After needed working of the adherend, the pressure sensitive adhesive sheet according to the present invention is separated and recovered from the adherend.

The pressure sensitive adhesive sheet according to the present invention is **characterized in that** it can be bent toward the high thermally shrinkable base layer side when the terminal of the pressure sensitive adhesive sheet is heated from any one direction and be curled from one terminal unidirectionally into a tubular roll by further heating. When the pressure sensitive adhesive sheet according to the present invention is used as the back grinding tape for an adherend such as semiconductor wafer, it is possible, after working of the adherend for example by polishing, to float (lift up) the pressure sensitive adhesive sheet easily by bending the pressure sensitive adhesive sheet toward the high thermally shrinkable base layer side by heating it in any direction, i.e., independently of the heating direction, and separate it from the adherend by making the pressure sensitive adhesive sheet curl in one direction (unidirectionally) from one terminal to form a tubular roll by further heating. It is also possible to separate the pressure sensitive adhesive sheet without forming a tubular roll by bending it toward the high thermally shrinkable base layer side floating it from the adherend under heat and then, terminating heating. The method of working an adherend according to the present invention is **characterized in that**, after the pressure sensitive adhesive sheet according to the present invention is bonded to an adherend and the adherend is worked in a desired manner, the pressure sensitive adhesive sheet is bent toward the high thermally shrinkable base layer side to be locally floated from the adherend by heating the terminal of the pressure sensitive adhesive sheet from any one direction, and then separated from the adherend without formation of a tubular roll after the heating is terminated, for easier recovery of the separated pressure sensitive adhesive sheet. After processing of the adherend by the method of working an adherend according to the present invention, the pressure sensitive adhesive sheet according to the present invention can be separated and recovered from the adherend surface easily by heating from any one direction, and the separated pressure sensitive adhesive sheet can be recovered without difficulty, as it does not tumble in the processing apparatus.

The pressure sensitive adhesive sheet according to the present invention has a high thermally shrinkable base layer and a low thermally shrinkable base layer bonded to each other via a p self-adhesive layer. When the self-adhesive layer is an active energy ray-curable adhesive layer, it is possible to adjust the rigidity of the self-adhesive layer by irradiating it with active-energy ray after processing of the adherend before heat treatment, transmit the shrinkage stress of the high thermally shrinkable base layer to the low thermally shrinkable base layer efficiently and cause deformation (bending toward high thermally shrinkable base layer side and local floating from the adherend) of the pressure sensitive adhesive sheet by heating more efficiently. It is also possible to prevent the difficulty in separating the pressure sensitive adhesive sheet from the surface of the adhered such as semiconductor wafer, as the sheet is folded thereon after heating. The adhesive power to the adherend declines significantly and the high thermally shrinkable base layer deforms by shrinkage, leading to warpage toward the high thermally shrinkable base layer side and local floating of the external edge region of the pressure sensitive adhesive sheet by irradiation with active-energy ray after processing of the adherend and subsequent heat-treatment when the adhesive layer formed on the low thermally shrinkable base layer is an active energy ray-curable adhesive layer or by heat treatment when the adhesive layer formed on the low thermally shrinkable base layer is a pressure-sensitive adhesive layer. The pressure sensitive adhesive sheet may be heated from any one direction as needed during the separation operation, and the locally floated region may be formed all around the pressure sensitive adhesive sheet, as it is heated entirely. The heating temperature and the heating period of the pressure sensitive adhesive sheet can be determined properly according to the shrinkage ratio of the high thermally shrinkable base used, and the heating temperature is, for example, 70 to 180°C, preferably 70 to 140°C. The heating period is, for example, approximately 5 to 180 seconds. Alternatively, the irradiation condition, such as the irradiation intensity and irradiation period during the active-energy ray irradiation are not particularly limited and can be determined properly as needed, but the irradiation intensity and period are respectively, for example, approximately 50 to 2000 mJ/cm² and 1 to 180 seconds, when ultraviolet ray is used as the active-energy ray.

The pressure sensitive adhesive sheet according to the present invention, which is bent toward the high thermally shrinkable base layer side and floated locally from the adherend surface, can be recovered easily, for example, by bonding a release tape to the external edge region locally floated from the surface of the high thermally shrinkable base layer side of the pressure sensitive adhesive sheet, and pulling the bonded release tape upward. Since the pressure sensitive adhesive sheet according to the present invention is deformed and floated by approximately 5 to 15 mm from the external edge region of the adherend, it can be separated easily, even if the release tape is not bonded to the terminal of the pressure sensitive adhesive sheet (for example, if it is bonded inward from the position separated by approximately 4 mm from the external edge region of the pressure sensitive adhesive sheet). It is possible in this way to prevent adhesion of the release tape for example to the apparatus when the release tape is bonded to the pressure sensitive adhesive sheet and also fracture of the adherend such as semiconductor wafer during peeling separation. Since the pressure sensitive adhesive sheet is locally floated from the adherend, it is possible to make the peel angle during peeling separation larger as much as possible, thereby minimizing the peel stress and suppressing fracture of the adherend. Since the possibility of the adhesive torn off by the adherend is reduced when the peel stress is lower, it is also possible to minimize the possibility of contamination of the adherend by separation. Even if the adhesive deposits on the adherend, it is also possible to reduce the possibility of fracture of the adherend, because the peel stress can be minimized.

### [Separating device]

The device for separating the pressure sensitive adhesive sheet according to the present invention is a pressure sensitive adhesive sheet-separating device for use in processing of the adherend, having heating means for heating the pressure sensitive adhesive sheet bonded to the adherend and separating means for separating the pressure sensitive adhesive sheet bent toward the high thermally shrinkable base layer side and floated locally from the adherend by heating. The pressure sensitive adhesive sheet-separating device according to the present invention preferably has additionally means for fixing the polished wafer, active-energy ray irradiation means for curing the active energy ray-curable adhesive, and recovery means for recovering the separated pressure sensitive adhesive sheet. The separating device may be an integrated apparatus having all of these means or may have multiple independent apparatuses respectively having separate means.

The means of fixing a polished wafer is not particularly limited, if it can fix the adherend, such as semiconductor wafer, firmly without dislocation, even when stresses by various operations are applied in the series of steps for recovering the pressure sensitive adhesive sheet from the adherend carrying the bonded pressure sensitive adhesive sheet according to the present invention. For example, the adherend may be fixed temporarily on a stand equipped with a chuck operated by static electricity or air pressure, or permanently as the adherend is bonded to an adhesive-coated base having rigidity sufficient for fixing the adherend, or alternatively, the pressure sensitive adhesive sheet according to the present invention may be separated from polished wafer and bonded with a desirable material, similarly to a dicing adhesive having a die-attach film. In addition, the adherend-fixing apparatus may have a mechanism for conveying the adherend sequentially between the apparatuses needed for the separation operation.

The active-energy ray-exposure means is not particularly limited, if it can irradiate active-energy ray for curing the active energy ray-curable adhesive constituting the pressure sensitive adhesive sheet according to the present invention and, for example, an ultraviolet ray-irradiating device employing a light source generating ultraviolet ray efficiently, such as high-pressure mercury lamp, can be used.

The heating means is not particularly limited, if it can float the pressure sensitive adhesive sheet locally from the adherend such as semiconductor wafer surface for example by heating the polished wafer, and the heating means for use is an apparatus allowing rapid heating to the temperature at which the high thermally shrinkable base layer begins to shrink, and typical examples thereof include non-contact heating means such as driers, heat guns, and infrared lamps; heating means consisting of a stand equipped with an adherend-fixing chuck and a heat source embedded therein, and contact-type heating means such as heat rollers.

The heating method is not particularly limited, if it can heat the terminal edge of the pressure sensitive adhesive sheet from any one direction and, for example, only one of the pressure sensitive adhesive sheet surface and the semiconductor wafer surface of the polished semiconductor wafer, or both of them may be heated.

After the pressure sensitive adhesive sheet is bent toward the high thermally shrinkable base layer side and floated from the adherend locally by heating, the separated pressure sensitive adhesive sheet can be separated from the adherend such as semiconductor wafer by a tape-recovering apparatus. The tape-recovering method is specifically a method of recovering the pressure sensitive adhesive tape by using a release tape, specifically by bonding the release tape to the high thermally shrinkable base layer-sided surface of the region of the pressure sensitive adhesive sheet bent toward the high thermally shrinkable base layer side and floated locally from the adherend and recovering the pressure sensitive adhesive tape by peel separation, a method of recovering the pressure sensitive adhesive tape by allowing adsorption of an adsorption collet on the region of the pressure sensitive adhesive sheet bent toward the high thermally shrinkable base layer side and floated locally from the adherend, or a method of separating the pressure sensitive adhesive tape by picking up the region of the pressure sensitive adhesive sheet bent toward the high thermally shrinkable base layer side and floated locally from the adherend, with a robot arm. In particular, the method of separating the pressure sensitive adhesive sheet by peel separation by using a release tape is preferable in the pressure sensitive adhesive sheet-separating device according to the present invention.

The device for separating the pressure sensitive adhesive sheet according to the present invention is preferably a pressure sensitive adhesive sheet-separating device having a suction hot stage for fixing and heating the pressure sensitive adhesive sheet-bonded adherend and a release tape for peel separation, as it is bonded to the external edge surface region in the high thermally shrinkable base layer side of the pressure sensitive adhesive sheet; a pressure sensitive adhesive sheet-separating device having a suction stage for fixing the pressure sensitive adhesive sheet-bonded adherend, a heat gun and a release tape for peel separation as it is bonded to the external edge surface region in the high thermally shrinkable base layer side of the pressure sensitive adhesive sheet; a pressure sensitive adhesive sheet-separating device having a suction stage for fixing the pressure sensitive adhesive sheet-bonded adherend, and a mechanism of bonding a release tape (a means for bonding a release tape) and containing an internal heater for heating separation of the pressure sensitive adhesive sheet; or a pressure sensitive adhesive sheet-separating device having a suction stage for fixing the pressure sensitive adhesive sheet-bonded adherend, as well as a movable heat source, and a mechanism (means) of driving the heat source from one terminal to the other terminal of the adherend. The pressure sensitive adhesive sheet-separating device according to the present invention is preferably a pressure sensitive adhesive sheet-separating device additionally having an active-energy ray source for curing the self-adhesive layer. The active-energy ray source preferably has an ultraviolet ray-irradiating source.

It is possible, by using the pressure sensitive adhesive sheet-separating device according to the present invention, to smoothly separate and recover a pressure sensitive adhesive sheet according to the present invention bonded to the surface of an adherend, such as semiconductor wafer, for protection of the adherend in the processing steps thereof, which pressure sensitive adhesive sheet is not needed any more after the adherend-processing step, without contamination or fracture of the adherend such as semiconductor wafer.

### Examples

Hereinafter, the present invention will be described more specifically with reference to Examples, but it should be understood that the present invention is not restricted by these Examples.

### Preparative Example 1-1

100 weight parts of an acrylic polymer (trade name: "Leocoat R1020S", manufactured by Daiichi Lace), 10 weight parts of a pentaerythritol-modified acrylate crosslinking agent (trade name: "DPHA40H", manufactured by NIPPON KAYAKU Co., Ltd.), 0.25 weight part of a crosslinking agent (trade name: "TETRAD C", manufactured by MITSUBISHI GAS CHEMICAL COMPANY, INC.), 2 weight parts of a crosslink agent (trade name: "CORONATE L", manufactured by NIPPON POLYURETHANE INDUSTRY CO., LTD. CO., LTD.), and 3 weight parts of an active energy ray polymerization initiator (trade name: "Irgacure 651", manufactured by Nihon Ciba-Geigy K.K) were dissolved in toluene to give a polymer solution 1 having a solid matter concentration of 15 weight %. The polymer solution 1 obtained was coated and dried on a polyethylene terephthalate film (trade name: "LUMIRROR S10", manufactured by Toray Industries Inc., surface-processed PET film for printing, thickness: 38 µm, rigidity at 80°C: 1.41×10⁵ N/m) as a low thermally shrinkable base layer to a dried thickness of 30 µm by using a coating machine, to form a self-adhesive layer. Then, a biaxially stretched polyester film (trade name: "SPACECLEAN 57200", manufactured by TOYOBO CO., LTD. CO., LTD., thickness: 30 µm, ratio (A:B) of the shrinkage ratio in the main shrinkage direction [A (%)] to the shrinkage ratio in the direction perpendicular to the main shrinkage direction [B (%)]: 40:40) was laminated on the self-adhesive layer as a high thermally shrinkable base layer to give a resin laminate 1.

### Preparative Example 1-2

A polymer solution 1 was obtained in a manner similar to the Preparative Example 1-1 above. The polymer solution 1 obtained was coated and dried on a polyethylene terephthalate film (trade name: "LUMIRROR S10", manufactured by Toray Industries Inc., surface-processed PET film for printing, thickness: 50 µm, rigidity at 80°C: 1.86×10⁵ N/m) as a low thermally shrinkable base layer to a dried thickness of 30 µm by using a coating machine to form a self-adhesive layer. Then, a biaxially stretched polyester film (trade name; "SPACECLEAN 57200", manufactured by TOYOBO CO., LTD. CO., LTD., thickness: 30 µm, ratio (A:B) of the shrinkage ratio in the main shrinkage direction [A (%)] to the shrinkage ratio in the direction perpendicular to the main shrinkage direction [B (%)]: 40:40) was laminated on the self-adhesive layer as a high thermally shrinkable base layer to give a resin laminate 2.

### Preparative Example 1-3

100 weight parts of an acrylic polymer: 2-ethylhexyl acrylate/acrylic acid (90 weight parts /10 weight parts) copolymer, 10 weight parts of dipentaerythritol hexaacrylate and 3 weight parts of an active energy ray polymerization initiator (trade name: "Irgacure 651", manufactured by Nihon Ciba-Geigy K.K.) were dissolved in toluene to give a polymer solution 2 having a solid matter concentration of 15 weight %. The polymer solution 2 obtained was coated and dried on a polyethylene terephthalate film (trade name: "LUMIRROR S10", manufactured by Toray Industries Inc., surface-processed PET film for printing, thickness: 38 µm, rigidity at 80°C: 1,41×10⁵ N/m) as a low thermally shrinkable base layer to a dried thickness of 30 µm by using a coating machine, to form a self-adhesive layer. Then, a biaxially stretched polyester film (trade name: "SPACECLEAN 57200", manufactured by TOYOBO CO., LTD. CO., LTD., thickness: 30 µm, ratio (A:B) of the shrinkage ratio in the main shrinkage direction [A (%)] to the shrinkage ratio in the direction perpendicular to the main shrinkage direction [B (%)]: 40:40) was laminated on the self-adhesive layer as a high thermally shrinkable base layer to give a resin laminate 3.

### Preparative Example 1-4

A polymer solution 2 was obtained in a manner similar to the Preparative Example 1-3 above. The polymer solution 2 obtained was coated and dried on a polyethylene terephthalate film (trade name: ""LUMIRROR S10", manufactured by Toray Industries Inc., surface-processed PET film for printing, thickness: 50 µm, rigidity at 80°C: 1.86×10⁵) N/m) as a low thermally shrinkable base layer to a dried thickness of 30 µm by using a coating machine to form a self-adhesive layer. Then, a biaxially stretched polyester film (trade name: "SPACECLEAN 57200", manufactured by TOYOBO CO., LTD. CO., LTD., thickness: 30 µm, ratio (A:B) of the shrinkage ratio in the main shrinkage direction [A (%)] to the shrinkage ratio in the direction perpendicular to the main shrinkage direction [B (%)]: 40:40) was laminated on the self-adhesive layer as a high thermally shrinkable base layer to give a resin laminate 4.

### Preparative Example 1-5

A polymer solution 1 was obtained in a manner similar to the Preparative Example 1-1 above. The polymer solution 1 obtained was coated and dried on a polyethylene terephthalate film (trade name: "LUMIRROR S10", manufactured by Toray Industries Inc., surface-processed PET film for printing, thickness: 38 µm, rigidity at 80°C: 1.41×10⁵ N/m) as a low thermally shrinkable base layer to a dried thickness of 30 µm by using a coating machine to form a self-adhesive layer. Then, a uniaxially stretched polyester film (trade name: "SPACECLEAN 56630", manufactured by TOYOBO CO., LTD. CO., LTD., thickness: 60 µm, ratio (A:B) of the shrinkage ratio in the main shrinkage direction [A (%)] to the shrinkage ratio in the direction perpendicular to the main shrinkage direction [B (%)]: 70:0) was laminated on the self-adhesive layer as a high thermally shrinkable base layer to give a resin laminate 5.

### Preparative Example 1-6

A polymer solution 1 was obtained in a manner similar to the Preparative Example 1-1 above. The polymer solution 1 obtained was coated and dried on a polyethylene terephthalate film (trade name: "LUMIRROR S10", manufactured by Toray Industries Inc., surface-processed PET film for printing, thickness: 50 µm, rigidity at 80°C: 1.86×10⁵ N/m) as a low thermally shrinkable base layer to a dried thickness of 30 µm by using a coating machine to form a self-adhesive layer. Then, a uniaxially stretched polyester film (trade name: "SPACECLEAN 56630", manufactured by TOYOBO CO., LTD. CO., LTD., thickness: 60 µm, ratio (A:B) of the shrinkage ratio in the main shrinkage direction [A (%)] to the shrinkage ratio in the direction perpendicular to the main shrinkage direction [B (%)]: 70:0) was laminated on the self-adhesive layer as a high thermally shrinkable base layer to give a resin laminate 6.

### Preparative Example 1-7

100 weight parts of an ester-based polymer (polymer obtained from 100 weight parts of trade name "PLACCEL CD220PL" (manufactured by DAICEL CHEMICAL INDUSTRIES, LTD.), and 10 weight parts of sebacic acid) and 4 weight parts of a crosslinking agent (trade name: "CORONATE L", manufactured by NIPPON POLYURETHANE INDUSTRY CO., LTD. CO., LTD.) were dissolved in toluene to give a polymer solution 3 having a solid matter concentration of 20 weight %. The polymer solution 3 obtained was coated and dried on a polyethylene terephthalate film (trade name: "LUMIRROR S10", manufactured by Toray Industries Inc., surface-processed PET film for printing, thickness: 38 µm, rigidity at 80°C: 1.41×10⁵ N/m) as a low thermally shrinkable base layer to a dried thickness of 30 µm by using a coating machine, to form a self-adhesive layer. Then, a biaxially stretched polyester film (trade name: "SPACECLEAN 57200", manufactured by TOYOBO CO., LTD. CO., LTD., thickness 30: µm, ratio (A:B) of the shrinkage in the main shrinkage direction [A (%)] to the shrinkage ratio in the direction perpendicular to the main shrinkage direction [B (%)]: 40:40) was laminated on the self-adhesive layer as a high thermally shrinkable base layer to give a resin laminate 7.

### Preparative Example 1-8

A polymer solution 1 was obtained in a manner similar to the Preparative Example 1-1 above. The polymer solution 1 obtained was coated and dried on a polyethylene terephthalate film (trade name: "Melinex ", manufactured by Teijin DuPont Films Japan Limited, thickness: 100 µm, rigidity at 80°C: 3.38×10⁵ N/m) as a low thermally shrinkable base layer to a dried thickness of 30 µm by using a coating machine to form a self-adhesive layer Then, a biaxially stretched polyester film (trade name: "SPACECLEAN S7200", manufactured by TOYOBO CO., LTD., thickness: 30µm, ratio (A:B) of the shrinkage ratio in the main shrinkage direction [A (%)] to the shrinkage ratio in the direction perpendicular to the main shrinkage direction [B (%)]: 40:40) was laminated on the self-adhesive layer as a high thermally shrinkable base layer, to give a resin laminate 8.

### Preparative Example 2-1

80% of the 2-hydroxyethyl acrylate-derived hydroxyl groups in an acrylic polymer [butyl acrylate/ethyl acrylate/2-hydroxyethyl acrylate (50/50/20 weight parts) copolymer] were bonded to 2-isocyanatoethyl methacrylate to give an acrylic polymer having methacrylate groups on the side chains. 100 weight parts of the acrylic polymer obtained, 50 weight parts of pentaerythritol tetraacrylate (trade name: "Viscoat 400", manufactured by OSAKA ORGANIC CHEMICAL INDUSTRY LTD), 1.5 weight parts of a crosslinking agent (trade name: "CORONATE L", manufactured by "NIPPON POLYURETHANE INDUSTRY CO., LTD.), 6 weight parts of an active energy ray polymerization initiator (trade name: "Irgacure 184", manufactured by Nihon Ciba-Geigy K.K.), and 40 weight parts of a thickener (trade name: "MX500", manufactured by Soken Chemical & Engineering Co., Ltd., polymethyl methacrylate beads) were dissolved in ethyl acetate to give a polymer solution 4 having a solid matter concentration of 30 weight %. The polymer solution 4 obtained was coated and dried on a separator (trade name: "MRF38", manufactured by Mitsubishi Polyester Film) to a dried thickness of 30 µm by using a coating machine to form an adhesive layer 1.

### Preparative Example 2-2

80% of the 2-hydroxyethyl acrylate-derived hydroxyl groups in an acrylic polymer [butyl acrylate/ethyl acrylate/2-hydroxy acrylate (50/50/20 weight parts) copolymer] were bonded to 2-isocyanatoethyl methacrylate to give an acrylic polymer having methacrylate groups on the side chains. 100 weight parts of the acrylic polymer obtained, 100 weight parts of a modified pentaerythritol tetraacrylate (trade name: "Shikoh V1700", manufactured by Nippon Synthetic Chemical Industry Co., Ltd.), 1.5 weight parts of a crosslinking agent (trade name: "CORONATE L", manufactured by NIPPON POLYURETHANE INDUSTRY CO., LTD.), and 3 weight parts of an active energy ray polymerization initiator (trade name: "Irgacure 184", manufactured by Nihon Ciba-Geigy K.K.) were dissolved in ethyl acetate to give a polymer solution 5 having a solid matter concentration of 30 weight %. The polymer solution 5 obtained was coated and dried on a separator (trade name: "MRF38", manufactured by Mitsubishi Polyester Film) to a dried thickness of 35 µm by using a coating machine to form an adhesive layer 2.

### Example 1

The adhesive layer 1 obtained in Preparative Example 2-1 was laminated on the low-thermally shrinkable base of the resin laminate 1 obtained in Preparative Example 1-1 to give a pressure sensitive adhesive sheet 1.

### Example 2

The adhesive layer 1 obtained in Preparative Example 2-1 was laminated on the low-thermally shrinkable base of the resin laminate 2 obtained in Preparative Example 1-2 to give a pressure sensitive adhesive sheet 2.

### Example 3

The adhesive layer 1 obtained in Preparative Example 2-1 was laminated on the low-thermally shrinkable base of the resin laminate 3 obtained in Preparative Example 1-3 to give a pressure sensitive adhesive sheet 3.

### Example 4

The adhesive layer 1 obtained in Preparative Example 2-1 was laminated on the low-thermally shrinkable base of the resin laminate 4 obtained in Preparative Example 1-4 to give a pressure sensitive adhesive sheet 4.

### Example 5.

The adhesive layer 2 obtained in Preparative Example 2-2 was laminated on the low-thermally shrinkable base of the resin laminate 1 obtained in Preparative Example 1-1 to give a pressure sensitive adhesive sheet 5.

### Example 6

The adhesive layer 2 obtained in Preparative Example 2-2 was laminated on the low-thermally shrinkable base of the resin laminate 2 obtained in Preparative Example 1-2 to give a pressure sensitive adhesive sheet 6.

### Example 7

The adhesive layer 2 obtained in Preparative Example 2-2 was laminated on the low-thermally shrinkable base of the resin laminate 3 obtained in Preparative Example 1-3 to give a pressure sensitive adhesive sheet 7.

### Example 8

The adhesive layer 2 obtained in Preparative Example 2-2 was laminated on the low-thermally shrinkable base of the resin laminate 4 obtained in Preparative Example 1-4 to give a pressure sensitive adhesive sheet 8.

### Example 9

The adhesive layer 2 obtained in Preparative Example 2-2 was laminated on the low-thermally shrinkable base of the resin laminate 7 obtained in Preparative Example 1-7 to give a pressure sensitive adhesive sheet 9.

### Comparative Example 1

The adhesive layer 1 obtained in Preparative Example 2-1 was laminated on the low-thermally shrinkable base of the resin laminate 5 obtained in Preparative Example 1.5 to give a pressure sensitive adhesive sheet 10.

### Comparative Example 2

The adhesive layer 1 obtained in Preparative Example 2-1 was laminated on the low-thermally shrinkable base of the resin laminate 6 obtained in Preparative Example 1-6 to give a pressure sensitive adhesive sheet 11.

### Comparative Example 3

The adhesive layer 2 obtained in Preparative Example 2-2 was laminated on the low-thermally shrinkable base of the resin laminate 8 obtained in Preparative Example 1-8 to give a pressure sensitive adhesive sheet 12.

The properties of the pressure sensitive adhesive sheets 1 to 12 obtained in the Examples and Comparative Examples above as a back grinding tape, and also the separation efficiency thereof were evaluated by the following methods.

### [Measurement of the shear elastic modulus of self-adhesive layer at 80°C]

A self-adhesive layer prepared by coating and drying the polymer solution obtained in the Preparative Example on a separator to a dried thickness of 2 mm was punched with a punch having a diameter of 7.9 mm to give a test sample. The shear elastic modulus thereof at 80°C was determined by using a viscoelasticity spectrometer (ARES) manufactured by Rheometric Scientific Inc. at a chuck pressure of 100 gram-weight and a shearing frequency of 1 Hz.

### [Measurement of the Young's modulus of low thermally shrinkable base layers at 80°C]

The shear elastic modulus of the low thermally shrinkable base layer used in the Preparative Example was determined by the following method according to JIS K7127. The tensile tester used was Autograph AG-1kNG (with heating hood) manufactured by Shimadzu Corporation. The low thermally shrinkable base cut to a length of 200 mm and a width of 10 mm was placed in the tester at a chuck distance of 100 mm. The sample was stretched at a tension speed of 5 mm/minute under an environment adjusted to 80°C in the heat hood and the stress-strain relationship was determined. The loads and the Young's moduluses respectively at strains of 0.2% and 0.45% were determined. The measurement was repeated five times with the same sample, and the average was used.

### [Measurement of the adhesive power of self-adhesive layer to high thermally shrinkable base layer]

The adhesive power of the self-adhesive layer to the high thermally shrinkable base layer was determined by 180° peel test method at 50°C. Each of the resin laminates 1 to 6 obtained in Preparative Examples 1-1 to 1-6 above was cut into a test piece having a width of 10 mm, and the surface of the low thermally shrinkable base layer side was bonded to a 1 mm-thickness silicon wafer with a pressure sensitive adhesive tape and irradiated with UV (500 mJ/cm², 25 seconds), to give a test sample. The obtained test sample was placed on a heat stage (heater) at 50°C, with the silicon wafer surface facing it. The test sample was stretched toward the 180° direction at a tension speed of 300 mm/min by using the tensile jig of a peel separation test apparatus, to determine the tensile force (N/10 mm) when the high thermally shrinkable base layer is separated locally from the self-adhesive layer. For removal of the measurement error due to the difference in thickness of the low-thermally shrinkable bases, the thickness of the low-thermally shrinkable base was normalized to 38 µm.

### [Measurement of the adhesive power of the pressure sensitive adhesive sheet to silicon wafer]

The adhesive power of the pressure sensitive adhesive sheet to the silicon wafer was determined by the 180° peel test method at 25°C. Each of the pressure sensitive adhesive sheets 1 to 12 obtained in Examples and Comparative Examples was cut to a test piece having a width of 10 mm and bonded to a silicon mirror wafer after the separator was removed. Two kinds of samples irradiated with ultraviolet ray in the state (500 mJ/cm², 25 seconds) and not irradiated with UV ray were prepared. Each sample was stretched at a tension speed of 300 mm/min in 180° direction by using the tensile jig of a peel separation test apparatus to determine the tensile force (N/10 mm) when the pressure sensitive adhesive sheet was separated locally from the silicon mirror wafer.

### [Evaluation of back-grinding efficiency]

Each of the pressure sensitive adhesive sheets 1 to 11 obtained in Examples and Comparative Examples above was bonded to an 8-inch wafer having a V notch, after the separator was removed. During the bonding, the wafer was bonded in such a manner that the V notch thereof is located in parallel with the main shrinkage direction of the high thermally shrinkable base layer of each pressure sensitive adhesive sheet or in the direction orthogonal thereto. Then, the 8-inch wafer having a V notch and carrying the bonded pressure sensitive adhesive sheet was polished to a wafer thickness of 25 µm by using a back grinding apparatus (trade name: "DFG8560", manufactured by DISCO Corporation) to give a polished wafer. The polished wafer obtained was evaluated by visual observation according to the criteria shown below. The wafer thickness was determined by measuring the thickness of the laminate including the pressure sensitive adhesive sheet and the polished wafer, and subtracting the thickness of the pressure sensitive adhesive sheet from it.

### Evaluation criteria

No fracture or cracking observed in wafer: O
Fracture and cracking observed in wafer: ×

### [Evaluation of separability]

Each polished wafer obtained in evaluation of the back-grinding efficiency was irradiated with UV ray from the side of the pressure sensitive adhesive sheet face (500 mJ/cm², 25 seconds). Then, each UV-irradiated polished wafer was placed in a tape-bonding device (trade name: "MA3000 II", manufactured by Nitto Seiki Co., Ltd.) and a DAF tape (trade name: "EM-500 M2A"manufactured by NITTO DENKO CORPORATION) fixed on the dicing ring was bonded to the wafer face, and the resulting composite was placed in a tape-separating device (trade name: "RM300", manufactured by Nitto Seiki Co., Ltd.). It was then heated from the face opposite to the V notch site by the drier or heater in the tape-separating device and the separability was evaluated according to the criteria below. The tape-separating device used was an apparatus modified to have a heating jig containing an internal drier or heater as the heat source for tape separation so as to heat a test sample by switching operation.

### Evaluation criteria

The pressure sensitive adhesive sheet is bent toward the high thermally shrinkable base layer side and the region of 5 mm or more inward from the terminal was lifted: O

The width of the region of the pressure sensitive adhesive sheet lifted from the terminal is less than 5 mm: ×

In addition, a release tape was bonded to the region of the high thermally shrinkable base layer face 5-mm inward from the external edge region after heating, the tape was separated by peeling toward the 180° direction, and the result was evaluated according to the following criteria:

### Evaluation criteria

The pressure sensitive adhesive sheet could be separated and recovered easily without contamination of the adherend: O

The pressure sensitive adhesive sheet was not separated, or separated insufficiently and thus, could not be recovered: ×

The evaluation results are summarized in Tables 1 and 2.

**[Table 1]**

| | | Example 1 | | Example 2 | | Example 3 | | Example 4 | | Example 5 | | Example 6 | |
|---|---|---|---|---|---|---|---|---|---|---|---|---|---|
| Shear elastic modulus of self-adhesive layer (MPa, 80°C) | | 720000 | | 720000 | | 47864 | | 47864 | | 720000 | | 720000 | |
| Shear elastic modulus of self-adhesive layer× thickness (N/m) | | 21.6 | | 21.6 | | 1.44 | | 1.44 | | 21.6 | | 21.6 | |
| Adhesive power of self-adhesive layer (N/10 mm, to high thermally shrinkable base layer, 50°C) | | 4.4 | | 4.4 | | 11.4 | | 11.4 | | 4.4 | | 4.4 | |
| Young's modulus of low thermally shrinkable base layer (GPa, 80°C) | | 3.72 | | 3.72 | | 3.72 | | 3.72 | | 3.72 | | 3.72 | |
| Young's modulus of low thermally shrinkable base layer × thickness (N/m) | | 1. 41 × 10⁵ | | 1. 86 × 10⁵ | | 1. 41 × 10⁵ | | 1. 86 × 10⁵ | | 1. 41 × 10⁵ | | 1. 86 × 10⁵ | |
| Adhesive power of pressure sensitive adhesive sheet (N/10 mm, to wafer, room temperature) | UV irradiated | 2.43 | | 1.94 | | 0.15 | | 0.10 | | 2.43 | | 1.94 | |
| | UV unirradiated | 0.01 or less | | 0.01 or less | | 0.01 or less | | 0.01 or éless | | 0.01 or less | | 0.01 or less | |
| Relationship between heating direction and main shrinkage direction | | Parallel | Perpendicular | Parallel | Perpendicular | Parallel | Perpendicular | Parallel | Perpendicular | Parallel | Perpendicular | Parallel | Perpendicular |
| Fracture and cracking by 25 µm polishing | | ○ | ○ | ○ | ○ | ○ | ○ | ○ | ○ | ○ | ○ | ○ | ○ |
| After heating by drier: local floating by 5 mm or more toward the high thermally shrinkable base layer side after heating by drier | | ○ | ○ | ○ | ○ | ○ | ○ | ○ | ○ | ○ | ○ | ○ | ○ |
| After heating by drier separation | | ○ | ○ | ○ | ○ | ○ | ○ | ○ | ○ | ○ | ○ | ○ | ○ |
| After heating by heater: local floating by 5 mm or more toward the high thermally shrinkable base layer side | | ○ | ○ | ○ | ○ | ○ | ○ | ○ | ○ | ○ | ○ | ○ | ○ |
| After heating by heater :separation | | ○ | ○ | ○ | ○ | ○ | ○ | ○ | ○ | ○ | ○ | ○ | ○ |

**[Table 2]**

| | | Example 7 | | Example 8 | | Example 9 | | Comparative Example 1 | | Comparative Example 2 | | Comparative Example 3 | |
|---|---|---|---|---|---|---|---|---|---|---|---|---|---|
| Shear elastic modulus of self-adhesive layer (MPa, 80°C) | | 47864 | | 47864 | | 288000 | | 720000 | | 720000 | | 720000 | |
| Shear elastic thickness (N/m) layer × | | 1.44 | | 1.44 | | 8.64 | | 21.6 | | 21.6 | | 21.6 | |
| Adhesive power of self-adhesive layer (N/10 mm, to high thermally shrinkable base layer, 50°C) | | 11.4 | | 11.4 | | 13.0 | | 4.4 | | 4.4 | | 4.4 | |
| Young's modulus of low thermally shrinkable base layer (GPa, 80°C) | | 3.72 | | 3.72 | | 3.72 | | 3.72 | | 3.72 | | 3.38 | |
| Young's modulus of low thermally shrinkable base layer × thickness (N/m) | | 1.41 × 10⁵ | | 1.86 × 10⁵ | | 1.41 × 10⁵ | | 1.41 × 10⁵ | | 1.86 × 10⁵ | | 3.38 × 10⁵ | |
| Adhesive power of pressure sensitive adhesive sheet (N/10 mm, to wafer, room temperature) | UV irradiated | 2.43 | | 1.94 | | 2.43 | | 0.15 | | 0.10 | | 1.01 | |
| | UV unirradiated | 0.01 or less | | 0.01 or less | | 0.01 or less | | 0.01 or less | | 0. 01 or less | | 0.01 or less | |
| Relationship between heating direction and main shrinkage direction | | Parallel | Perpendicular | Parallel | Perpendicular | Parallel | Perpendicular | Parallel | Perpendicular | Parallel | Perpendicular | Parallel | Perpendicular |
| Fracture and cracking by 25 µm polishing | | ○ | ○ | ○ | ○ | ○ | ○ | ○ | ○ | ○ | ○ | - | - |
| After heating by drier : local floating by 5 mm or more toward the high thermally shrinkable base layer side after heating by drier | | ○ | ○ | ○ | ○ | ○ | ○ | ○ | × | ○ | × | × | × |
| After heating by drier :separation | | ○ | ○ | ○ | ○ | ○ | ○ | ○ | × | ○ | × | × | × |
| After heating by heater : local floating by 5 mm or more toward the high thermally shrinkable base layer side | | ○ | ○ | ○ | ○ | ○ | ○ | ○ | × | ○ | × | × | × |
| After heating by heater :separation | | ○ | ○ | ○ | ○ | ○ | ○ | ○ | × | ○ | × | × | × |

As shown in Table 1, each of the pressure sensitive adhesive sheet 1 to 9 obtained in Examples 1 to 9, which used a biaxial shrinkable base layer as the high thermally shrinkable base layer, bent toward the high thermally shrinkable base layer side and floated locally the pressure sensitive adhesive sheet from the adherend in the region 5 mm or more inward from the terminal (peeling initiation point), when the terminal of the high thermally shrinkable base layer in the main shrinkage direction was heated or when the external edge in the direction perpendicular to the main shrinkage direction was heated, and thus, could be separated with a release tape smoothly by peeling, without contamination of the adherend. On the other hand, the pressure sensitive adhesive sheets 10 and 11 obtained in Comparative Examples 1 and 2, which used only a unidirectionally-stretched uniaxial shrinkable substrate layer as the high thermally shrinkable base layer, bent toward the high thermally shrinkable base layer side (giving a peeling initiation point) only when the terminal in the shrinkage direction was heated and did not bend toward the high thermally shrinkable base layer side (not giving the peeling initiation point) and could not be separated when the terminal in the direction perpendicular to the shrinkage direction was heated. In addition, the pressure sensitive adhesive sheet 12 obtained in Comparative Example 3, which had a too thicker low thermally shrinkable base layer, did not bend toward the high thermally shrinkable base layer side (giving no peeling initiation point) and could not be separated, when the terminal of the high thermally shrinkable base layer in the main shrinkage direction was heated or the terminal in the direction perpendicular to the main shrinkage direction was heated

### [Evaluation of practical performance of pressure sensitive adhesive sheet]

Each of the pressure sensitive adhesive sheets 1 to 9 showing the separability above was bonded to an 8-inch wafer having a V notch after the separator was removed. Then, the 8-inch wafer with a V notch carrying the pressure sensitive adhesive sheet bonded thereto was polished to a wafer thickness of 25 µm by using a back-grinding apparatus (trade name: "DFG8560", manufactured by DISCO Corporation) to give a polished wafer. Each polished wafer obtained was irradiated with UV ray from the side of the pressure sensitive adhesive sheet face (500 mJ/cm², 25 seconds). Then, each UV-irradiated polished wafer was placed in a tape-bonding device (trade name "MA3000II", manufactured by Nitto Seiki Co., Ltd.), and a DAF tape (trade name: "EM-500 M2A", manufactured by NITTO DENKO CORPORATION) fixed on a dicing ring was bonded to the wafer face, as the wafer was heated to 50 to 60°C. The adhesive sheets 1 to 9 were not separated by heating to 50 to 60°C.

It was then transferred to and placed in a tape-separating device (trade name: "RM300", manufactured by Nitto Seiki Co., Ltd). Subsequently, a terminal of the pressure sensitive adhesive sheet was heated as hot air was blown onto the pressure sensitive adhesive sheet side by an industrial drier, generating a peeling initiation point, and the pressure sensitive adhesive sheet was separated by using a release tape. There was no fracture or cracking generated in the wafer. In addition, there was no increase in the adhesive power of the DAF tape (trade name: "EM-500 M2A", manufactured by NITTO DENKO CORPORATION) by blowing of hot air with the industrial drier. The results above show that the pressure sensitive adhesive sheets according to the present invention are distinctively superior in practical performance in semiconductor wafer processing.

### Industrial Applicability

The pressure sensitive adhesive sheet according to the present invention bends toward the high thermally shrinkable base layer side when heated and curl automatically into a tubular roll by further heating. Thus, the pressure sensitive adhesive sheet after heating does not fold itself on the surface of the adherend, making it difficult to separate, thereby allowing east and complete removal of the unneeded pressure sensitive adhesive sheet. For that reason, it is useful as a pressure sensitive adhesive sheet for use for example in semiconductor wafer polishing (back grinding).

## Claims

1. A resin laminate comprising
a high thermally shrinkable base layer,
a low thermally shrinkable base layer, and
a self-adhesive layer,
wherein the high thermally shrinkable base layer having relatively high thermal shrinkage ratio and having a ratio (A:B) of the thermal shrinkage ratio in a main shrinkage direction [A (%)] to the shrinkage ratio in a direction perpendicular to the main shrinkage direction [B (%)] of 1:1 to 10:1,
the low thermally shrinkable base layer having relatively low thermal shrinkage ratio,
the high and low thermally shrinkable base layers bonded to each other via the self-adhesive layer, and
the resin laminate bends toward the high thermally shrinkable base layer side when a terminal of the resin laminate is heated from any one direction and can automatically curl in one direction from one terminal to form a tubular roll by further heating.

2. The resin laminate according to Claim 1, comprising the high thermally shrinkable base layer shrinking in an amount of 5% or more in two axial directions perpendicular to each other when heated at a particular temperature in the range of 60 to 180°C, and
the low thermally shrinkable base layer having a heat shrinkage ratio of less than 1% at the same temperature.

3. The resin laminate according to Claim 1 or 2, wherein a rigidity (product of shear elastic modulus and thickness) of the self-adhesive layer at 80°C is 1 to 10³ N/m.

4. The resin laminate according to any one of Claims 1 to 3, wherein the self-adhesive layer contains an acrylic polymer.

5. The resin laminate according to any one of Claims 1 to 4, wherein the self-adhesive layer is an active energy ray-curable adhesive layer.

6. The resin laminate according to Claim 5, wherein the active energy ray-curable adhesive layer contains a side-chain acrylate-containing acrylic polymer, a crosslinking agent, and an ultraviolet ray/active energy ray polymerization initiator.

7. The resin laminate according to any one of Claims 1 to 6, wherein a product of the Young's modulus and the thickness of the low thermally shrinkable base layer at 80°C is 3×10⁵ N/m or less.

8. A pressure sensitive adhesive sheet, comprising the resin laminate according to any one of Claims 1 to 7, and an adhesive layer formed on the low thermally shrinkable base layer thereof.

9. The pressure sensitive adhesive sheet according to Claim 8, wherein the adhesive layer formed on the low thermally shrinkable base layer contains beads of glass or resin.

10. A method for working an adherend, comprising bonding the pressure sensitive adhesive sheet according to Claim 8 or 9 to an adherend, working the adherend in a desired manner, bending the pressure sensitive adhesive sheet toward the high thermally shrinkable base layer side to be locally floated from the adherend by heating a terminal of the pressure sensitive adhesive sheet from any one direction, and separating the pressure sensitive adhesive sheet.

11. The method for working an adherend according to Claim 10, wherein the pressure sensitive adhesive sheet having an active energy ray-curable adhesive layer is used as the self-adhesive layer, the pressure sensitive adhesive sheet is bonded to the adherend; the adherend is worked in a desired manner, the self-adhesive layer is cured by irradiation of the active-energy ray, and then the pressure sensitive adhesive sheet is bent toward the high thermally shrinkable base layer side to be locally floated from the adherend by heating a terminal of the pressure sensitive adhesive sheet from any one direction.

12. The method of working an adherend according to Claim 10 or 11, wherein the pressure sensitive adhesive sheet is separated, as a release tape bonded to an external edge surface region in the high thermally shrinkable base layer side of a deformed pressure sensitive adhesive sheet is pulled upward.

13. A device for separating the pressure sensitive adhesive sheet for use in the method of working an adherend according to any one of Claims 10 to 12, comprising heating means for heating the pressure sensitive adhesive sheet bonded to the adherend, and separating means for separating the pressure sensitive adhesive sheet bent toward the high thermally shrinkable base layer side and floated locally from the adherend by heating.

14. The device for separating the pressure sensitive adhesive sheet according to Claim 13, further comprising a suction stage for fixing and heating the adherend to which the pressure sensitive adhesive sheet is bonded, and the release tape, for peel separation, bonded to the external edge surface region in the high thermally shrinkable base layer side of the pressure sensitive adhesive sheet.

15. The device for separating the pressure sensitive adhesive sheet according to Claim 13, further comprising the suction stage for fixing the pressure sensitive adhesive sheet-bonded adherend, a heat gun, and the release tape, for peel separation, bonded to the external edge surface region in the high thermally shrinkable base layer side of the pressure sensitive adhesive sheet.

16. The device for separating the pressure sensitive adhesive sheet according to Claim 13, further comprising the suction stage for fixing the pressure sensitive adhesive sheet-bonded adherend, and a mechanism of bonding a release tape containing an internal heater for heating separation of the pressure sensitive adhesive sheet.

17. The device for separating the pressure sensitive adhesive sheet according to Claim 13, further comprising a suction stage for fixing the pressure sensitive adhesive sheet-bonded adherend, as well as a movable heat source and a mechanism of driving the heat source from one terminal to the other terminal of the adherend.

18. The device for separating the pressure sensitive adhesive sheet according to any one of Claims 13 to 17, further comprising an active-energy ray source for curing the self-adhesive layer by irradiation of the pressure sensitive adhesive sheet having an active energy ray-curable adhesive layer with an active-energy ray.

19. The device for separating the pressure sensitive adhesive sheet according to Claim 18, wherein the active-energy ray source is an ultraviolet ray-exposing source.
